(19) Europäisches Patentamt
European Patent Office
Office européen des brevets

(11) EP 1 906 239 A2

(12) **EUROPEAN PATENT APPLICATION**

(43) Date of publication:
**02.04.2008 Bulletin 2008/14**

(51) Int Cl.:
***G03F 7/004*** *(2006.01)* ***G03F 7/039*** *(2006.01)*

(21) Application number: **07018106.0**

(22) Date of filing: **14.09.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **29.09.2006 JP 2006267852**

(71) Applicant: **FUJIFILM Corporation**
**Minato-ku**
**Tokyo (JP)**

(72) Inventors:
- **Sugimoto, Naoya**
  **c/o Fujifilm Corporation**
  **Shizuoka (JP)**
- **Nishiyama, Fumiyuki**
  **c/o Fujifilm Corporation**
  **Shizuoka (JP)**

(74) Representative: **HOFFMANN EITLE**
**Patent- und Rechtsanwälte**
**Arabellastrasse 4**
**81925 München (DE)**

(54) **Positive resist composition and pattern forming method using the same**

(57) A positive resist composition, comprises: (A) a resin containing a repeating unit represented by formula (I); (B) a compound capable of generating an acid upon irradiation with actinic rays or radiation; and (C) a tertiary amine compound:

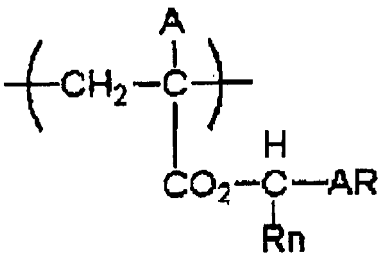

(I)

wherein AR represents a substituted or unsubstituted benzene ring or a substituted or unsubstituted naphthalene ring; Rn represents a substituted or unsubstituted alkyl group, a substituted or unsubstituted cycloalkyl group or a substituted or unsubstituted aryl group; and A represents an atom or group selected from the group consisting of a hydrogen atom, a substituted or unsubstituted alkyl group, a substituted or unsubstituted cycloalkyl group, a halogen atom, a cyano group and a substituted or unsubstituted alkyloxycarbonyl group, and a pattern forming method uses the same.

EP 1 906 239 A2

## Description

### Background of the Invention

1. Field of the Invention

The present invention relates to a positive resist composition suitable for use in the ultramicrolithography process such as production of VLSI or a high-capacity microchip or in other photofabrication processes. More specifically, the present invention relates to a positive photoresist capable of forming a high-resolution pattern by using KrF excimer laser light, EUV light or the like, that is, a positive resist composition suitably usable for the fine processing of a semiconductor device, where KrF excimer laser light or EUV light is used, and a pattern forming method using the composition.

2. Description of the Related Art

In the process of producing a semiconductor device such as IC and LSI, fine processing by lithography using a photoresist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light At present, other than the excimer laser light, development of lithography using electron beam, X ray or EUV light is proceeding.

At the formation of an ultrafine pattern in the sub-micron or quarter-micron region by a lithography process using KrF excimer laser light or EUV light, the first condition is sufficiently high resolving power, and the pattern obtained is demanded to have an excellent pattern profile with higher rectangularity.

Also, in the lithography using KrF excimer laser light, enhancement of the side lobe margin is demanded. The side lobe indicates "film loss/opening of resist film", which is generated between original pattern parts when forming a dense hole pattern. In the case of forming a dense hole pattern by using a halftone mask, the lights from halftone parts are intensified with each other to form a point having high optical intensity in an unintended site. This is a cause of the side lobe and of course gives rise to a lithography defect and in turn, serious reduction in the yield of the device. Therefore, the resist is demanded to have a side lobe margin (a ratio between the exposure amount allowing for generation of side lobe and the optimal exposure amount of lithography) as large as possible. This safety margin is called a side lobe margin and defined by the following formula. Incidentally, a larger side lobe margin is better.

$$\text{Side lobe margin (\%)} = ((\text{minimum irradiation energy allowing for generation of side lobe margin} - \text{sensitivity})/\text{sensitivity} - 1)\times 100$$

Similarly, how to satisfy all of high sensitivity, high resolution, good pattern profile and good defocus latitude depended on line pitch is an important problem, and this problem needs to be solved.

As for the resist suitable for such a lithography process using KrF excimer laser light or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an alkali developer but becomes soluble in an alkali developer under the action of an acid (hereinafter simply referred to as a "phenolic acid-decomposable resin"), is being effectively used.

With respect to such a positive resist, there are known some resist compositions using a phenolic acid-decomposable resin obtained by copolymerizing an acid-decomposable acrylate monomer having an alicyclic group as the acid-decomposable group. Examples thereof include the resist compositions disclosed in JP-A-7-234511 (the term "JP-A" as used herein means an "unexamined published Japanese patent application"), U.S. Patent 5,561,194 and JP-A-11-95434.

However, it is not yet achieved at present to satisfy high resolution and side lobe margin in an ultrafine region.

### Summary of the Invention

An object of the present invention is to solve the problems in the technology for enhancing the performance at the fine processing of a semiconductor device using actinic rays or radiation, particularly, KrF excimer laser light or EUV light, and provide a positive resist composition capable of giving a good side lobe margin, and a pattern forming method

using the composition.

As a result of intensive studies on the resist composition, the present inventors have found that the object can be attained by using a specific phenolic acid-decomposable resin and a tertiary amine compound. The present invention has been accomplished based on this finding. That is, the above-described object can be attained by the following constructions.

(1) A positive resist composition, which comprises:

(A) a resin containing a repeating unit represented by formula (I);
(B) a compound capable of generating an acid upon irradiation with actinic rays or radiation; and
(C) a tertiary amine compound:

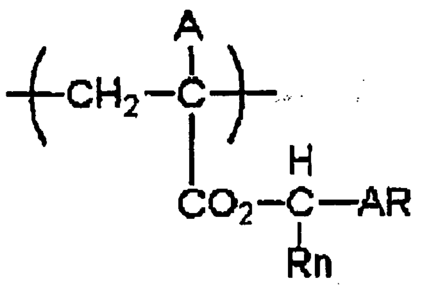

(I)

wherein AR represents a substituted or unsubstituted benzene ring or a substituted or unsubstituted naphthalene ring; Rn represents a substituted or unsubstituted alkyl group, a substituted or unsubstituted cycloalkyl group or a substituted or unsubstituted aryl group; and
A represents an atom or group selected from the group consisting of a hydrogen atom, a substituted or unsubstituted alkyl group, a substituted or unsubstituted cycloalkyl group, a halogen atom, a cyano group and a substituted or unsubstituted alkyloxycarbonyl group.
(2) The positive resist composition as described in (1) above,
wherein (C) the tertiary amine compound is represented by formula (II):

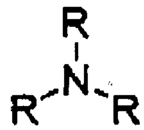

(II)

wherein three R's may be the same or different and each represents an alkyl or cycloalkyl group having a carbon number of 20 or less, which may contain a hydroxyl group, an ether group, a carbonyl group, an ester group, a lactone group, a carbonate group or a cyano group.
(3) The positive resist composition as described in (2) above,
wherein in the tertiary amine compound represented by formula (II), three R's are the same and each has a carbon number of 8 to 16.
(4) The positive resist composition as described in (2) above,
wherein in the tertiary amine compound represented by formula (II), at least one R is a cycloalkyl group.
(5) The positive resist composition as described in any of (1) to (4) above,
wherein the resin (A) further contains a repeating unit represented by formula (AI):

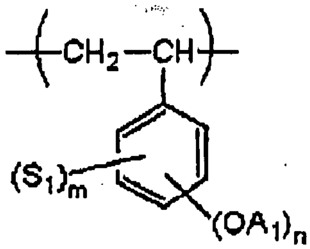

(A1)

wherein n represents an integer of 0 to 3;
m represents an integer of 0 to 3, provided that m+n≤5;
$A_1$ represents a group containing a group capable of decomposing under an action of an acid; and
$S_1$ represents a substituent, and when a plurality of $S_1$'s are present, the plurality of $S_1$'s may be the same or different.
(6) The positive resist composition as described in any of (1) to (5) above,
wherein in the repeating unit represented by formula (A1), the group containing a group capable of decomposing under an action of an acid represented by $A_1$ is an acetal group or a ketal group.
(7) The positive resist composition as described in any of (1) to (6) above,
wherein AR represents a benzene or a para-methyl benzene.
(8) A pattern forming method, which comprises:

forming a resist film from the positive resist composition as described in any of (1) to (7) above; and

exposing and developing the resist film.

**Detailed Description of the Invention**

The compounds for use in the present invention are described in detail below.
Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).
The resist composition of the present invention comprises (A) a resin containing a repeating unit represented by formula (I), (B) a compound capable of generating an acid upon irradiation with actinic rays or radiation, and (C) a tertiary amine compound.

[1] Resin containing a repeating unit represented by formula (I)

The resist composition of the present invention comprises (A) a resin containing a repeating unit represented by formula (I).

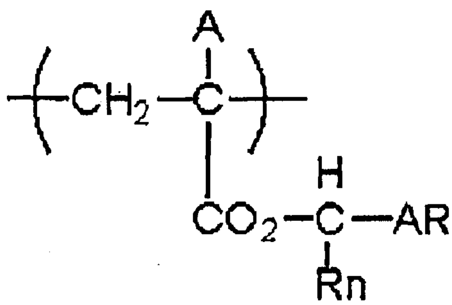

(I)

In formula (I), AR represents a benzene ring or a naphthalene ring, each of which may have one ore more substituent. As the substituent, a linear or branched alkyl group having a carbon number of 1 to 20, such as a methyl

group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group, and an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue are exemplified, and a linear or branched alkyl group having a carbon number of 1 to 5 is preferred in terms of a resolving power. AR is preferably benzene or para-methyl benzene.

Rn represents an alkyl group, a cycloalkyl group or an aryl group and is preferably a hydrogen atom or a methyl group.

A represents a hydrogen atom, an alkyl group, a cycloalkyl group, a halogen atom, a cyano group or an alkyloxycarbonyl group.

The alkyl group or cycloalkyl group of Rn is preferably an alkyl group or cycloalkyl group having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group. These groups each may have a substituent, and preferred examples of the substituent which these groups each may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. A substituent having a carbon number of 8 or less is preferred. Among these, an alkoxy group, a hydroxyl group, a halogen atom, a nitro group, an acyl group, an acyloxy group, an acylamino group and a sulfonylamino group are more preferred.

The aryl group of Rn is preferably an aryl group having a carbon number of 6 to 14, such as phenyl group, xylyl group, toluyl group, cumenyl group, naphthyl group and anthracenyl group.

The alkyl group or cycloalkyl group of A is preferably an alkyl group or cycloalkyl group having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group. These groups each may have a substituent, and preferred examples of the substituent which these groups each may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue, A substituent having a carbon number of 8 or less is preferred. Among these, a $CF_3$ group, an alkyloxycarbonylmethyl group, an alkylcarbonyloxymethyl group, a hydroxymethyl group and an alkoxymethyl group are more preferred.

The halogen atom of A includes a fluorine atom, a chlorine atom, a bromine atom and an iodine atom and is preferably a fluorine atom.

Examples of the alkyl contained in the alkyloxycarbonyl group of A are the same as those of the alkyl group of A above.

Specific examples of the repeating unit represented by formula (I) are set forth below, but the present invention is not limited thereto.

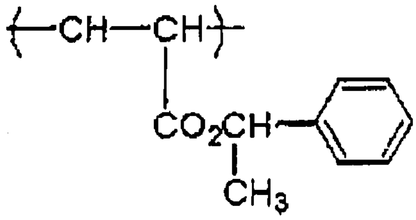

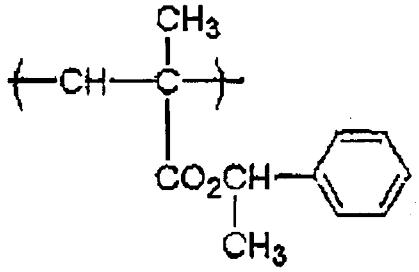

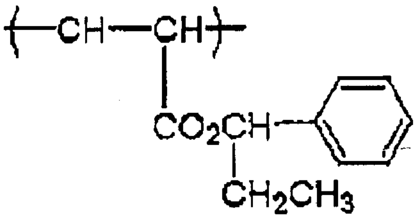

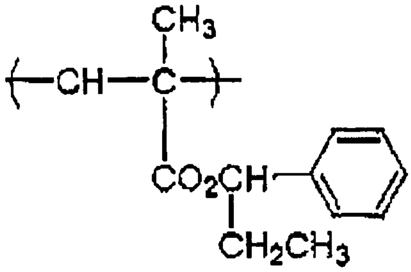

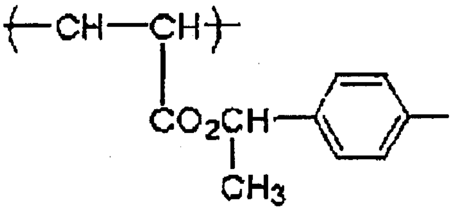

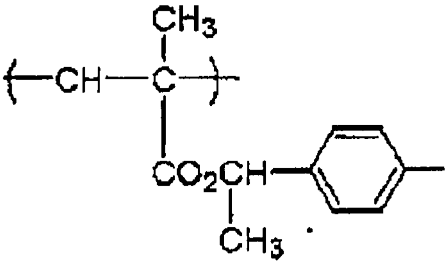

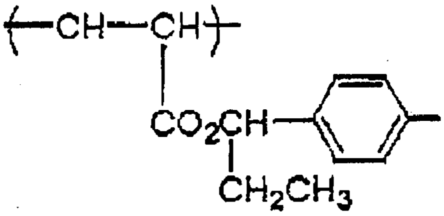

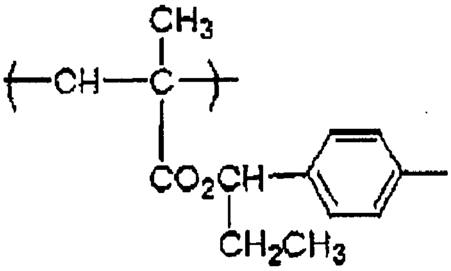

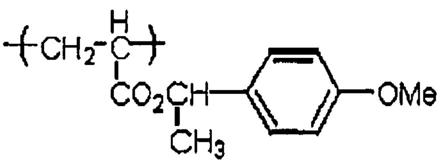

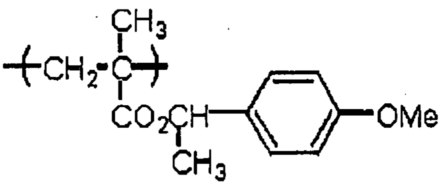

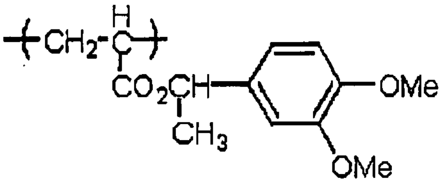

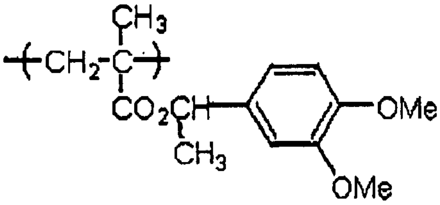

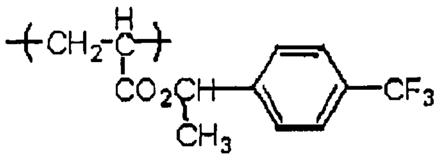

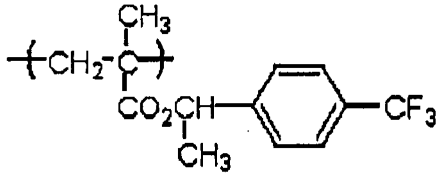

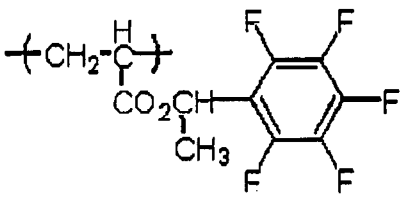

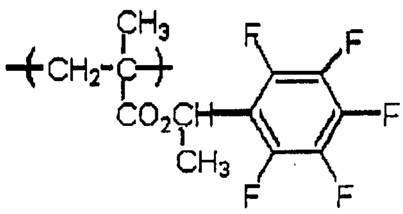

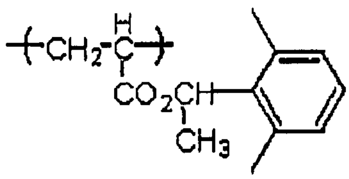

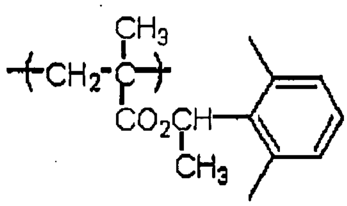

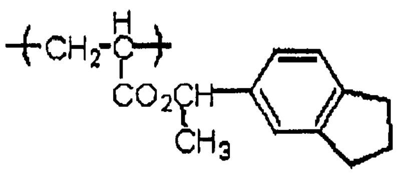

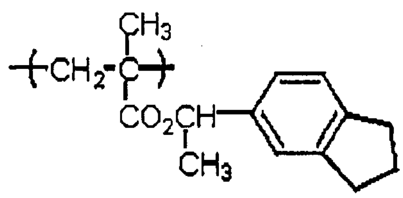

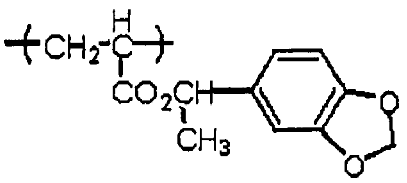

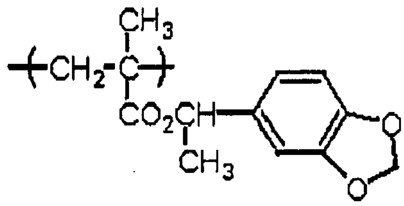

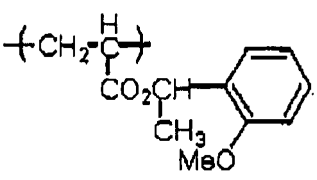

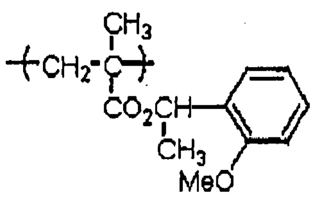

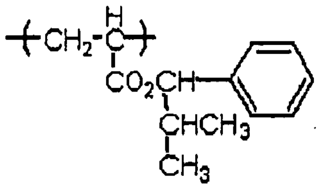

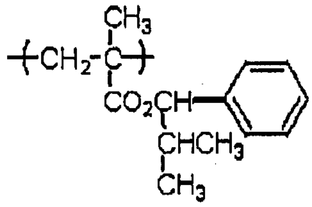

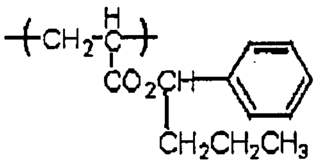

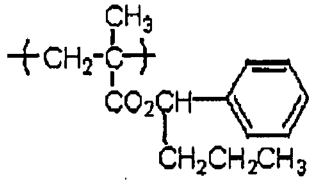

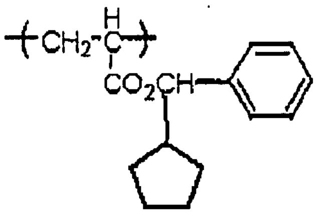

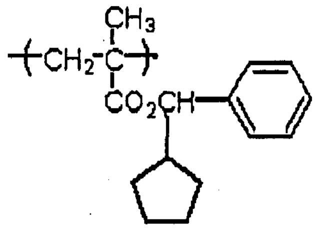

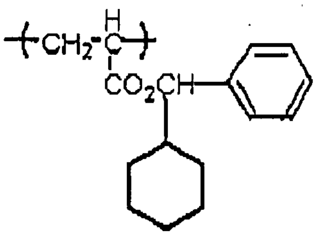

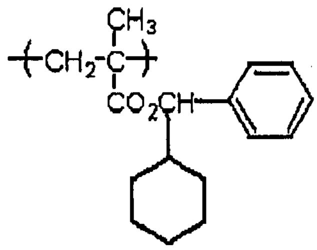

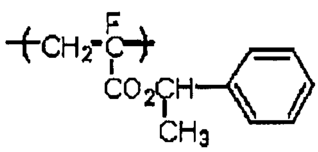

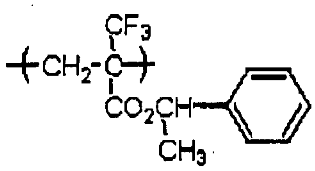

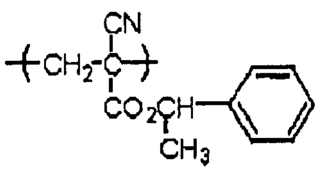

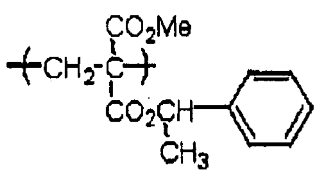

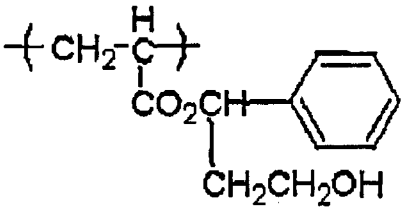

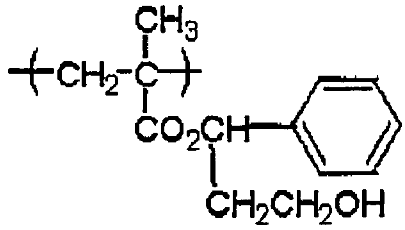

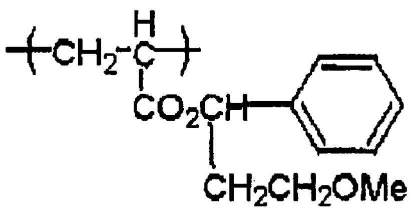

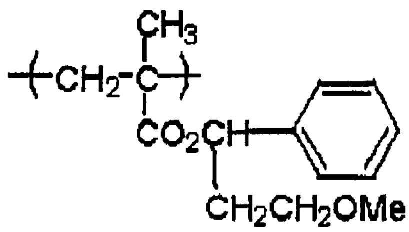

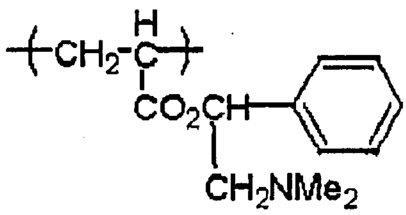

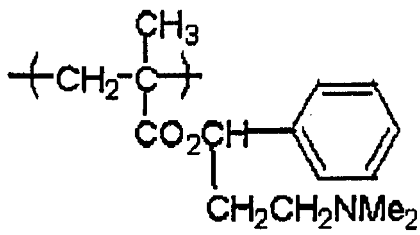

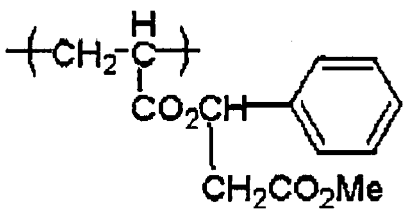

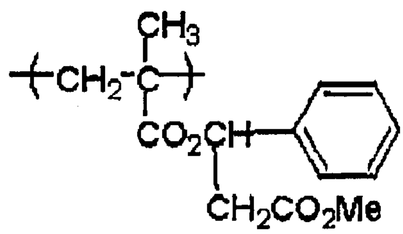

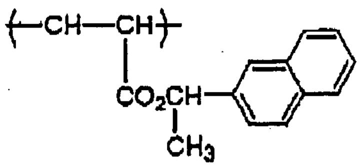

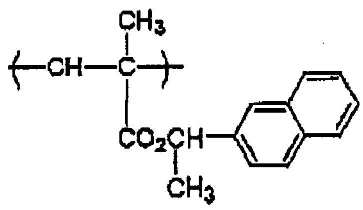

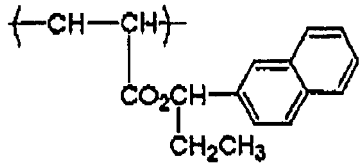

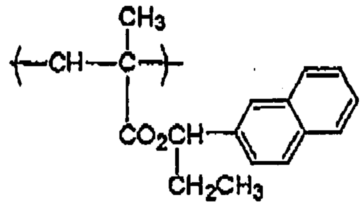

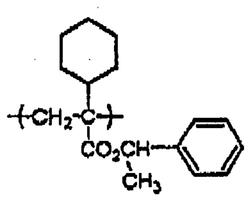

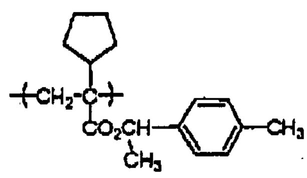

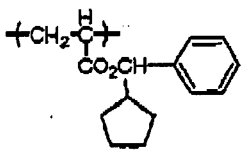

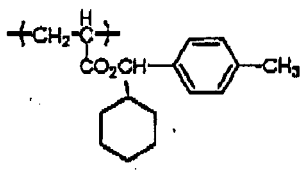

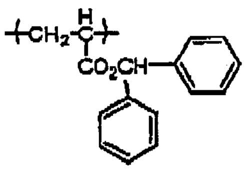

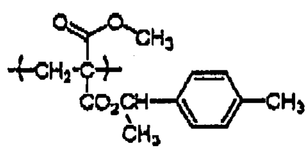

The (A) resin containing a repeating unit represented by formula (I) preferably further contains a repeating unit represented by formula (A1) or (A2).

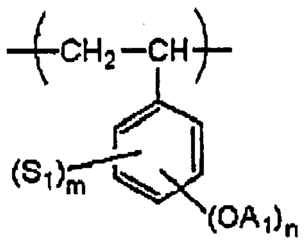

(A1)

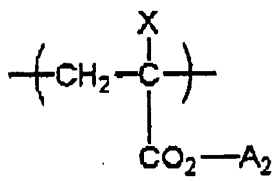

(A2)

In formula (A1), n represents an integer of 0 to 3, and m represents an integer of 0 to 3, provided that m+n≤5.

$A_1$ represents a group containing a group capable of decomposing under the action of an acid.

Specific examples thereof include a tertiary alkyl group such as tert-butyl group and tert-amyl group, a tert-butoxycarbonyl group, a tert-butoxycarbonylmethyl group, and an acetal group or a ketal group represented by -C($L_1$)($L_2$)-O-Z.

$L_1$ and $L_2$, which may be the same or different, each represents a hydrogen atom, an alkyl group, a cycloalkyl group or an aralkyl group. Preferably, $L_1$ is a methyl group and $L_2$ is a hydrogen atom.

Z represents an alkyl group, a cycloalkyl group or an aralkyl group and is preferably an ethyl group or a cyclohexyl group.

Z and $L_1$ may combine with each other to form a 5- or 6-membered ring.

n represents an integer of 0 to 4.

$S_1$ represents an arbitrary substituent and when a plurality of $S_1$'s are present, these may be the same or different. Examples thereof include an alkyl group, an alkoxy group, an acyl group, an acyloxy group, an aryl group, an aryloxy group, an aralkyl group, an aralkyloxy group, a hydroxy group, a halogen atom, a cyano group, a nitro group, a sulfonylamino group, an alkylthio group, an arylthio group and an aralkylthio group.

For example, the alkyl group or cycloalkyl group is preferably an alkyl group or cycloalkyl group having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group, and these groups each may further have a substituent. Preferred examples of the substituent which these groups each may further have include an alkyl group, an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, thiophenemethylcarbonyloxy group and a heterocyclic residue such as pyrrolidone residue. A substituent having a carbon number of 12 or less is preferred.

Examples of the alkyl group having a substituent include a cyclohexylethyl group, an alkylcarbonyloxymethyl group, an alkylcarbonyloxyethyl group, a cycloalkyl-carbonyloxymethyl group, a cycloalkylcarbonyloxyethyl group, an arylcarbonyloxyethyl group, an aralkylcarbonyloxyethyl group, an alkyloxymethyl group, a cycloalkyloxymethyl group, an aryloxymethyl group, an aralkyloxymethyl group, an alkyloxyethyl group, a cycloalkyloxyethyl group, an aryloxyethyl group, an aralkyloxyethyl group, an alkylthiomethyl group, a cycloalkylthiomethyl group, an arylthiomethyl group, an aralkylthiomethyl group, an alkylthioethyl group, a cycloalkylthioethyl group, an arylthioethyl group and an aralkylthioethyl group.

The alkyl group or cycloalkyl group in these groups is not particularly limited and may further have the above-described substituent such as alkyl group, cycloalkyl group and alkoxy group.

Examples of the alkylcarbonyloxyethyl group and cycloalkylcarbonyloxyethyl group include a cyclohexylcarbonyloxyethyl group, a tert-butylcyclohexylcarbonyloxyethyl group and an n-butylcyclohexylcarbonyloxyethyl group.

The aryl group is also not particularly limited but is generally an aryl group having a carbon number of 6 to 14, and examples thereof include a phenyl group, a xylyl group, a toluyl group, a cumenyl group, a naphthyl group and an anthracenyl group. These groups each may further have the above-described substituent such as alkyl group, cycloalkyl group and alkoxy group.

Examples of the aryloxyethyl group include a phenyloxyethyl group and a cyclohexylphenyloxyethyl group. These groups each may further have a substituent.

The aralkyl is also not particularly limited but examples thereof include a benzyl group.

Examples of the aralkylcarbonyloxyethyl group include a benzylcarbonyloxyethyl group, This group may further have a substituent.

Examples of the aralkyl group in $L_1$, $L_2$ and Z include an aralkyl group having a carbon number of 7 to 15, such as benzyl group and phenethyl group. These groups each may have a substituent.

Preferred examples of the substituent which the aralkyl group has include an alkoxy group, a hydroxyl group, a halogen atom, a nitro group, an acyl group, an acylamino group, a sulfonylamino group, an alkylthio group, an arylthio group and an aralkylthio group. Examples of the aralkyl group having a substituent include an alkoxybenzyl group, a hydroxybenzyl group and a phenylthiophenethyl group.

The carbon number of the substituent which the aralkyl group in $L_1$, $L_2$ or Z may have is preferably 12 or less.

Examples of the 5- or 6-membered ring formed resulting from Z and $L_1$ combining with each other include a tetrahydropyran ring and a tetrahydrofuran ring.

In the present invention, Z is preferably a linear or branched alkyl group. By virtue of this, the effects of the present invention are more successfully brought out.

In formula (A2), $A_2$ represents a group containing a group capable of decomposing under the action of an acid.

$A_2$ is preferably a hydrocarbon group (preferably having a carbon number of 20 or less, more preferably from 4 to 12), more preferably a tert-butyl group, a tert-amyl group or an alicyclic structure-containing hydrocarbon group (for example, an alicyclic group itself or a group where an alicyclic group is substituted to an alkyl group).

The alicylcic structure may be either monocyclic or polycyclic. Specific examples thereof include a monocyclo, bicyclo, tricyclo or tetracyclo structure having a carbon number of 5 or more. The carbon number is preferably from 6 to 30, more preferably from 7 to 25. The alicyclic structure-containing hydrocarbon group may have a substituent.

Examples of the alicyclic structure are set forth below.

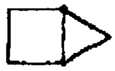
(1)

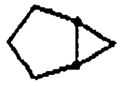
(2)

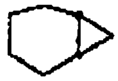
(3)

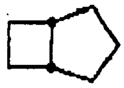
(4)

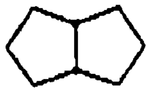
(5)

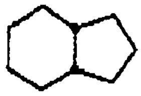
(6)

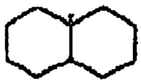
(7)

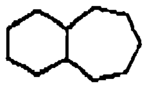
(8)

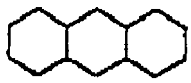
(9)

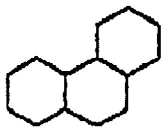
(10)

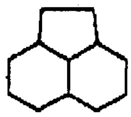
(11)

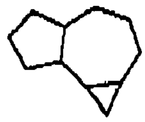
(12)

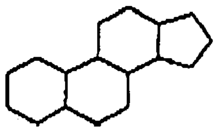
(13)

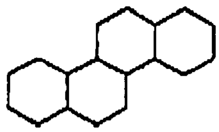
(14)

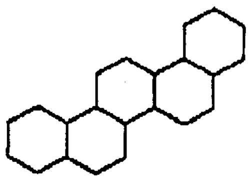
(15)

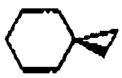
(16)

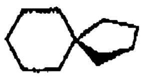
(17)

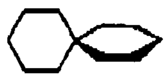
(18)

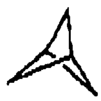
(19)

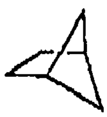
(20)

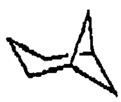
(21)

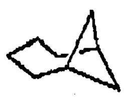
(22)

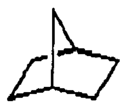
(23)

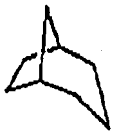
(24)

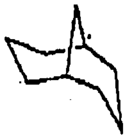
(25)

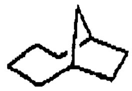
(26)

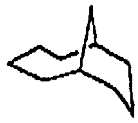
(27)

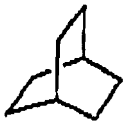
(28)

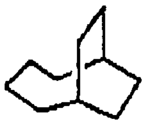
(29)

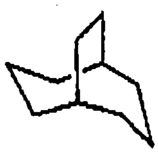
(30)

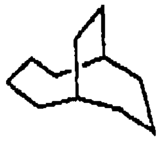
(31)

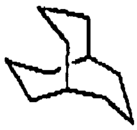
(32)

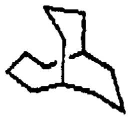
(33)

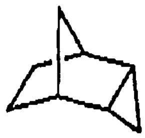
(34)

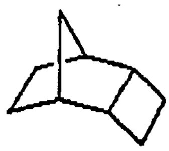
(35)

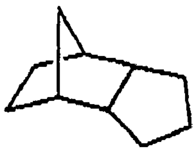
(36)

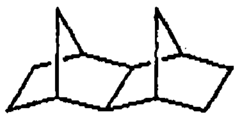
(37)

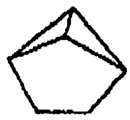
(38)

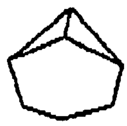
(39)

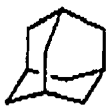
(40)

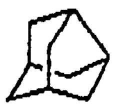
(41)

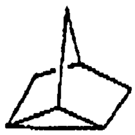
(42)

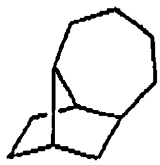
(43)

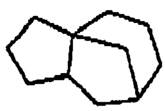
(44)

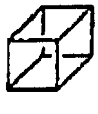
(45)

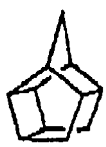
(46)

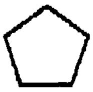 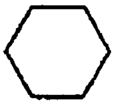 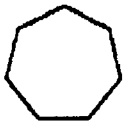 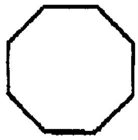

(47) (48) (49) (50)

In the present invention, among these alicyclic structures, as denoted in terms of the monovalent alicyclic group, preferred are an adamantyl group, a noradamantyl group, a decalin residue, a tricyclodecanyl group, a tetracyclododecanyl group, a norbornyl group, a cedrol group, a cyclohexyl group, a cycloheptyl group, a cyclooctyl group, a cyclodecanyl group and a cyclododecanyl group, more preferred are an adamantyl group, a decalin residue, a norbornyl group, a cedrol group, a cyclohexyl group, a cycloheptyl group, a cyclooctyl group, a cyclodecanyl group and a cyclododecanyl group.

Examples of the substituent which the alicyclic ring in these structures may have include an alkyl group, a halogen atom, a hydroxyl group, an alkoxy group, a carboxyl group and an alkoxycarbonyl group. The alkyl group is preferably a lower alkyl group such as methyl group, ethyl group, propyl group, isopropyl group and butyl group, more preferably a methyl group, an ethyl group, a propyl group or an isopropyl group. The alkoxy group includes an alkoxy group having a carbon number of 1 to 4, such as methoxy group, ethoxy group, propoxy group and butoxy group. The alkyl group and alkoxy group each may further have a substituent, and examples of the substituent which the alkyl group and alkoxy group may further have include a hydroxyl group, a halogen atom and an alkoxy group.

The acid-decomposable group having an alicyclic structure is preferably a group represented by any one of the following formulae (pI) to (pV):

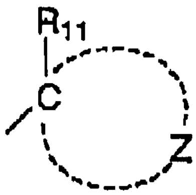

(pI)

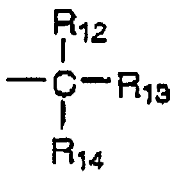

(pII)

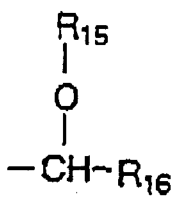

(pIII)

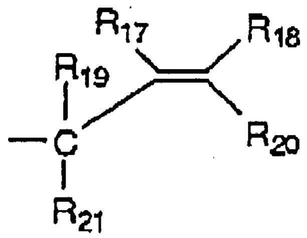 (pIV)

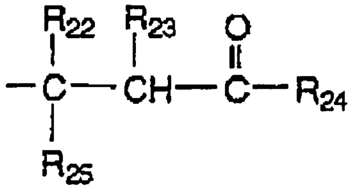 (pV)

In formulae (pI) to (pV), $R_{11}$ represents a methyl group, an ethyl group, an n-propyl group, an isopropyl group, an n-butyl group, an isobutyl group or a sec-butyl group. Z represents an atomic group necessary for forming an alicyclic hydrocarbon group together with the carbon atom.

$R_{12}$ to $R_{16}$ each independently represents a linear or branched alkyl group having a carbon number of 1 to 4 or an alicyclic hydrocarbon group, provided that at least one of $R_{12}$ to $R_{14}$ or either one of $R_{15}$ and $R_{16}$ represents an alicyclic hydrocarbon group.

$R_{17}$ to $R_{21}$ each independently represents a hydrogen atom, a linear or branched alkyl group having a carbon number of 1 to 4 or an alicyclic hydrocarbon group, provided that at least one of $R_{17}$ to $R_{21}$ represents an alicyclic hydrocarbon group. Also, either one of $R_{19}$ and $R_{21}$ represents a linear or branched alkyl group having a carbon number of 1 to 4 or an alicyclic hydrocarbon group.

$R_{22}$ to $R_{25}$ each independently represents a hydrogen atom, a linear or branched alkyl group having a carbon number of 1 to 4 or an alicyclic hydrocarbon group, provided that at least one of $R_{22}$ to $R_{25}$ represents an alicyclic hydrocarbon group. Also, $R_{23}$ and $R_{24}$ may combine with each other to form a ring.

In formulae (pI) to (pV), the alkyl group of $R_{12}$ to $R_{25}$ is a linear or branched alkyl group having from 1 to 4 carbon atoms, which may be substituted or unsubstituted, and examples of the alkyl group include a methyl group, an ethyl group, an n-propyl group, an isopropyl group, an n-butyl group, an isobutyl group, a sec-butyl group and a tert-butyl group.

Examples of the substituent which the alkyl group may further have include an alkoxy group having a carbon number of 1 to 4, a halogen atom (e.g., fluorine, chlorine, bromine, iodine), an acyl group, an acyloxy group, a cyano group, a hydroxyl group, a carboxy group, an alkoxycarbonyl group and a nitro group.

Examples of the alicyclic hydrocarbon group of $R_{11}$ to $R_{25}$ and the alicyclic hydrocarbon group formed by Z together with the carbon atom include those described above for the alicyclic structure.

Specific examples of the alicyclic structure-containing group capable of decomposing under the action of an acid (acid-decomposable group), represented by $A_2$, are set forth below.

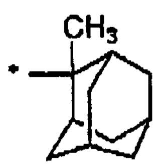

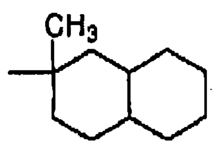

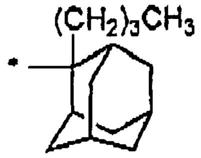
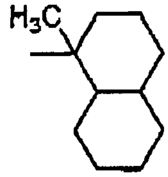

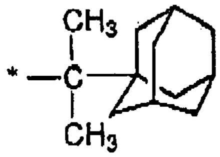
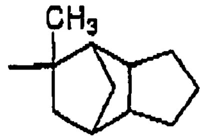

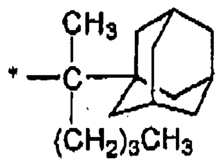
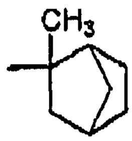

In the present invention, the group containing a group capable of decomposing under the action of an acid may be a group where as a result of desorption of $A_1$ or $A_2$, a hydroxyl group or a carboxyl group is produced in the repeating unit represented by formula (A1) or (A2), that is, a group capable of decomposing under the action of an acid (an acid-decomposable group) itself, or may be a group containing an acid-decomposable group, that is, a group where as a result of decomposition under the action of an acid, an alkali-soluble group such as hydroxyl group or carboxyl group is produced in the residue bonded to the repeating unit.

The monomer corresponding to the repeating unit represented by formula (I) or (A2) may be synthesized by esterifying a (meth)acrylic acid chloride and an alcohol compound in a solvent such as THF, acetone and methylene chloride in the presence of a basic catalyst such as triethylamine, pyridine and DBU. A commercially available product may also be used.

The monomer corresponding to the repeating unit represented by formula (A1) may be synthesized by acetalizing a hydroxy-substituted styrene monomer and a vinyl ether compound in a solvent such as THF and methylene chloride in the presence of an acidic catalyst such as p-toluenesulfonic acid and pyridine p-toluenesulfonate, or by effecting t-Boc protection with use of tert-butyl dicarboxylate in the presence of a basic catalyst such as triethylamine, pyridine and DBU. A commercially available product may also be used.

Specific examples of the repeating unit represented by formula (A1) are set forth below, but the present invention is not limited thereto.

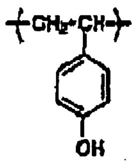
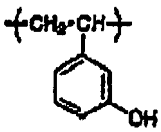
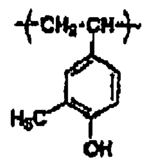
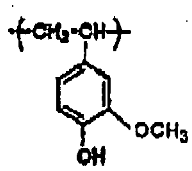
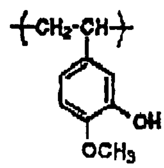

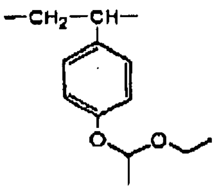
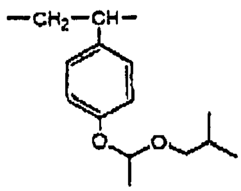
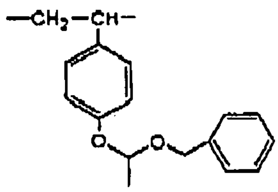

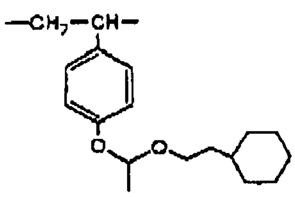
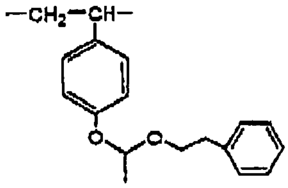
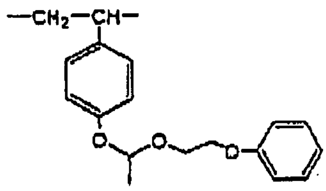

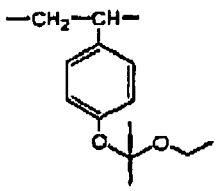
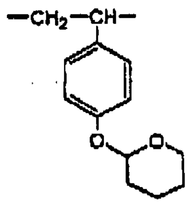
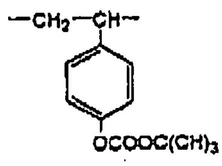

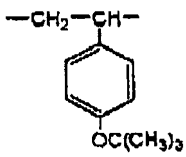
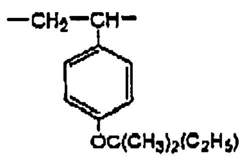

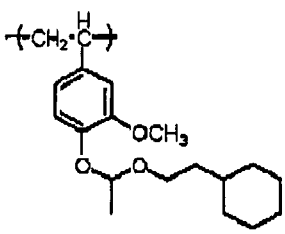
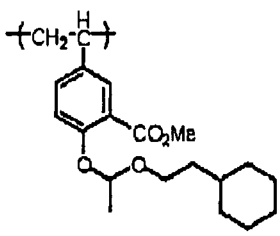

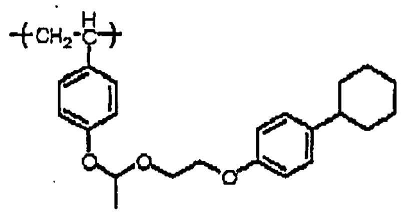

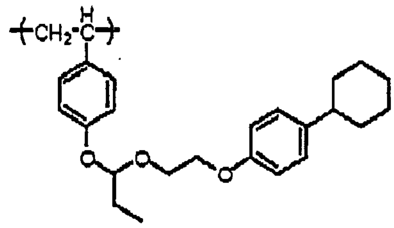

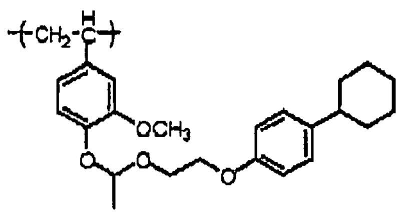

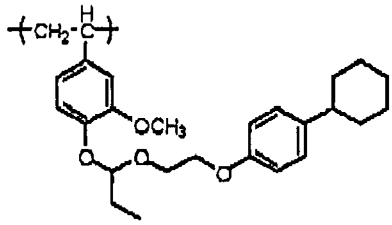

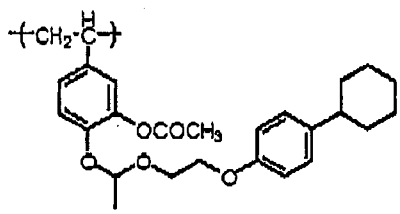

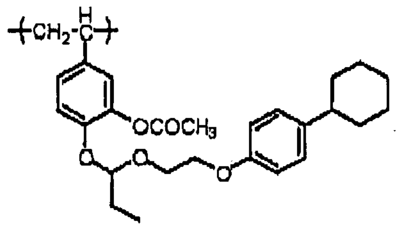

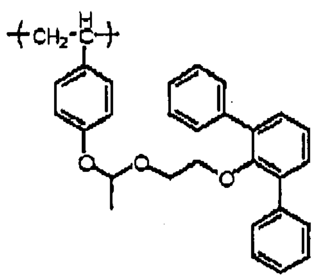

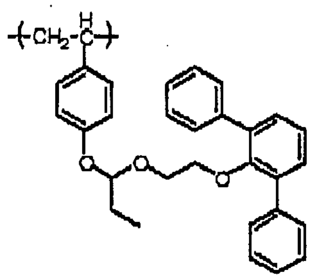

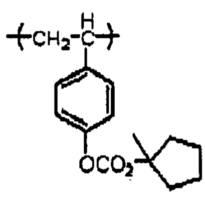

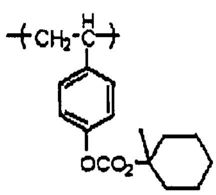

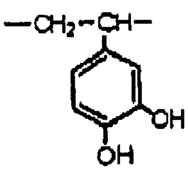 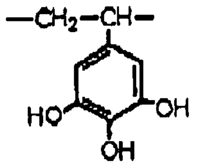 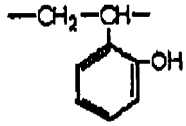 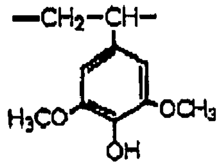

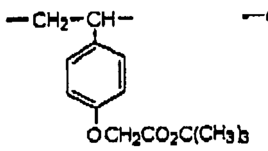 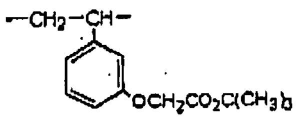 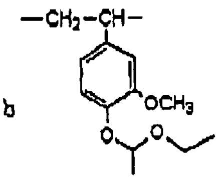 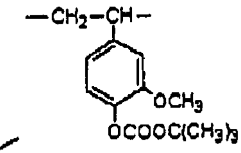

Specific examples of the repeating unit represented by formula (A2) are set forth below, but the present invention is not limited thereto.

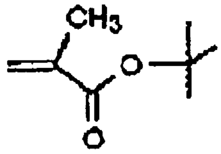 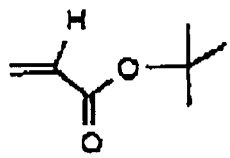

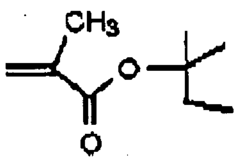 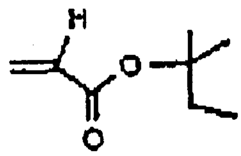

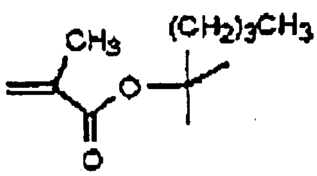 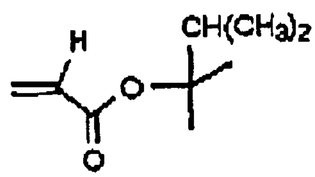

1 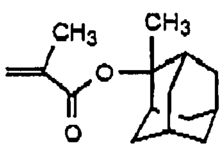 2 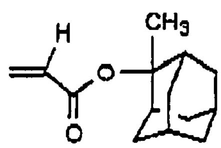

3 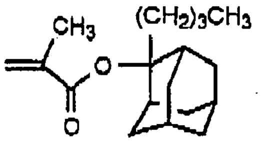

4 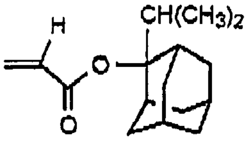

5 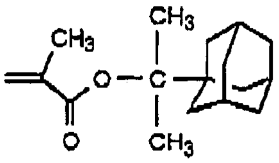

6 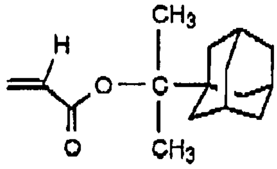

7 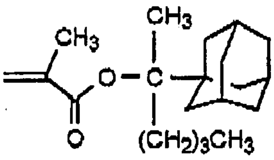

8 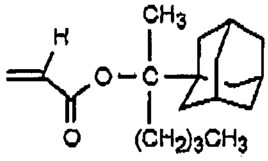

9 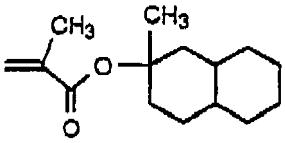

10 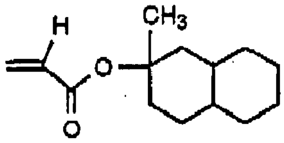

11 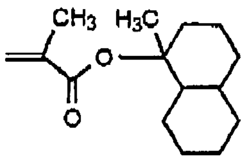

12 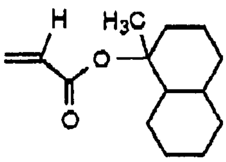

13 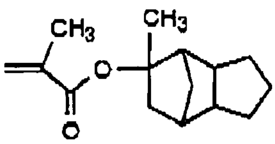

14 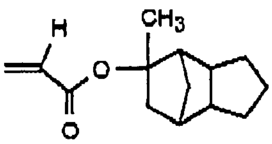

15 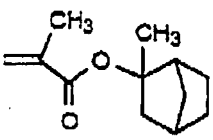

16 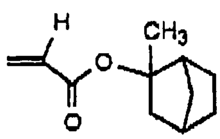

17 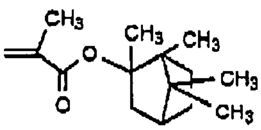

18 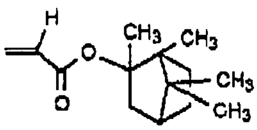

19 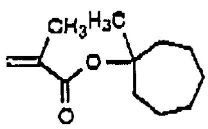

20 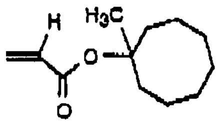

21 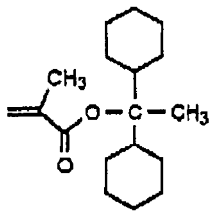

22 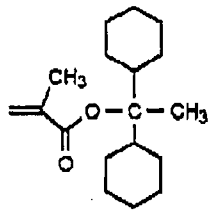

23 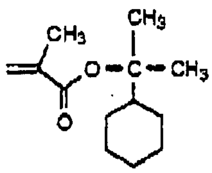

24 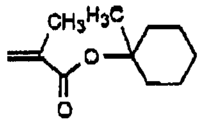

25 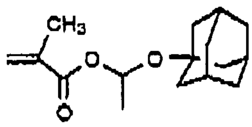

26 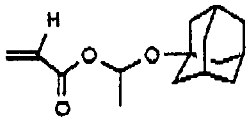

27 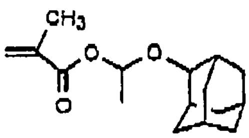

28 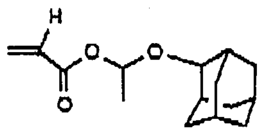

29 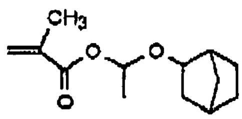

30 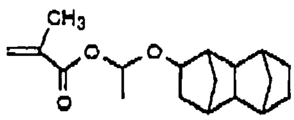

31 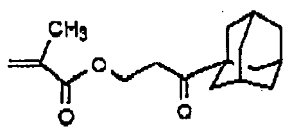

32 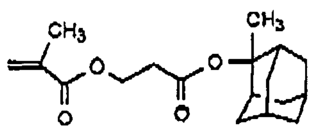

The resin (A) preferably further contains a repeating unit represented by formula (A4).

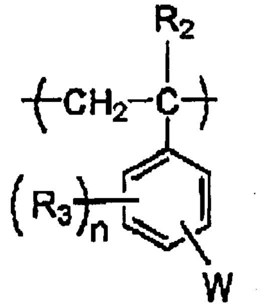
(A4)

In formula (A4), $R_2$ represents a hydrogen atom, a methyl group, a cyano group, a halogen atom or a perfluoro group (preferably having a carbon number of 1 to 4).

$R_3$ represents a hydrogen atom, an alkyl group, a halogen atom, an aryl group, an alkoxy group or an acyl group.

n represents an integer of 0 to 4.

W represents a group incapable of decomposing under the action of an acid.

W represents a group incapable of decomposing under the action of an acid (sometimes referred to as an "acid-stable group"), and specific examples thereof include a hydrogen atom, a halogen atom, an alkyl group, a cycloalkyl group, an alkenyl group, an aryl group, an acyl group, an alkylamido group, an arylamidomethyl group and an arylamido group. The acid-stable group is preferably an acyl group or an alkylamido group, more preferably an acyl group, an alkylcarbonyloxy group, an alkyloxy group, a cycloalkyloxy group or an aryloxy group.

In the acid-stable group represented by W, the alkyl group is preferably an alkyl group having a carbon number of 1 to 4, such as methyl group, ethyl group, propyl group, n-butyl group, sec-butyl group and tert-butyl group; the cycloalkyl group is preferably a cycloalkyl group having a carbon number of 3 to 10, such as cyclopropyl group, cyclobutyl group, cyclohexyl group and adamantyl group; the alkenyl group is preferably an alkenyl group having a carbon number of 2 to 4, such as vinyl group, propenyl group, allyl group and butenyl group; the alkenyl group is preferably an alkenyl group having a carbon number of 2 to 4, such as vinyl group, propenyl group, allyl group and butenyl group; and the aryl group is preferably an aryl group having a carbon number of 6 to 14, such as phenyl group, xylyl group, toluyl group, cumenyl group, naphthyl group and anthracenyl group. W may be present at any position on the benzene ring but is preferably present at the meta-position or para-position, more preferably at the para-position, of the styrene skeleton.

Specific examples of the repeating unit represented by formula (A4) are set forth below, but the present invention is not limited thereto.

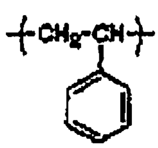
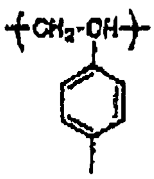
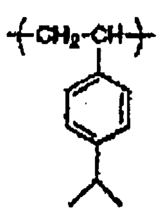
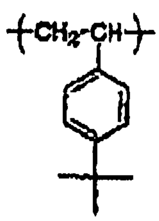

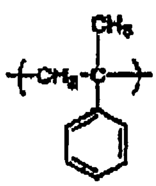
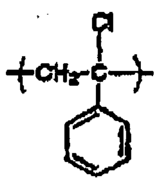
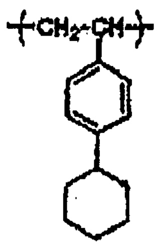
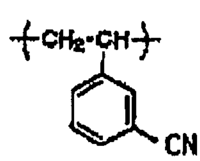

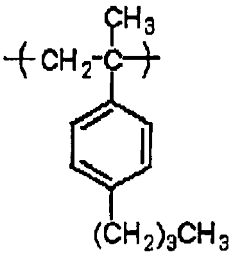 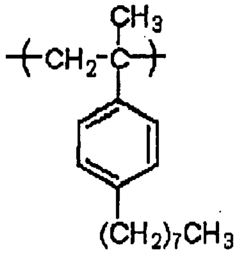 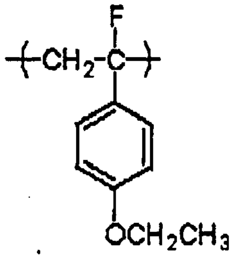 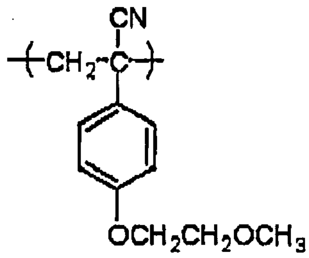

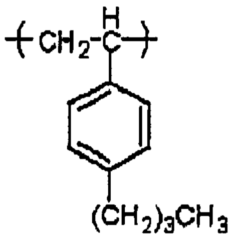 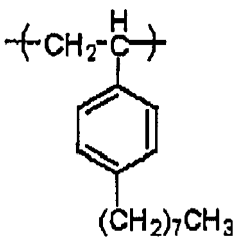 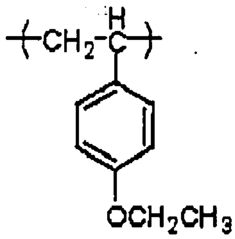 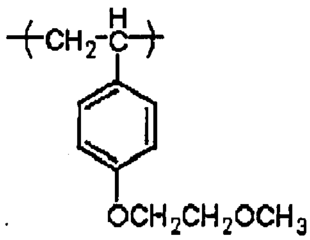

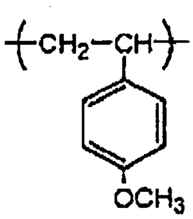 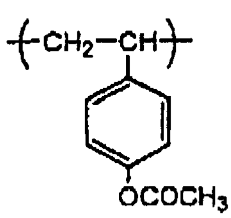 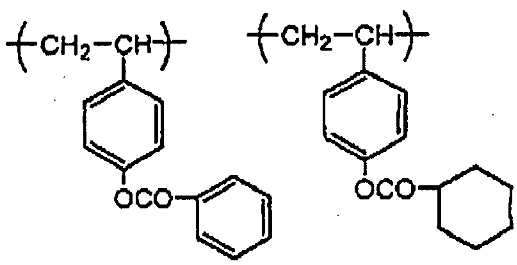

The resin (A) preferably further contains a repeating unit comprising a (meth)acrylic acid derivative incapable of decomposing under the action of an acid. Specific examples thereof are set forth below, but the present invention is not limited thereto.

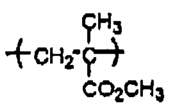 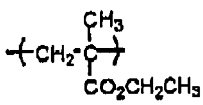 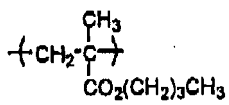 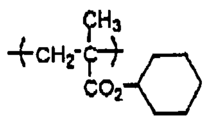

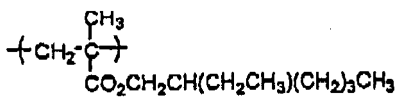 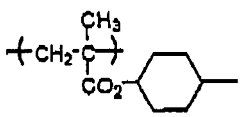 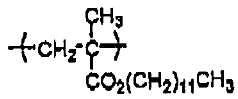

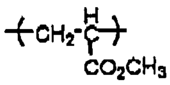 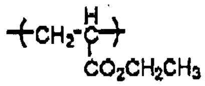 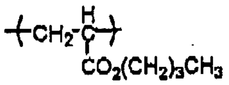 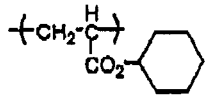

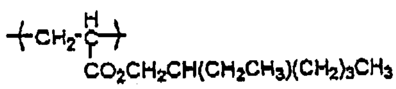 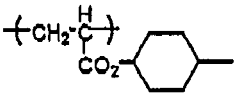 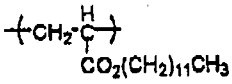

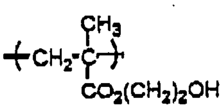 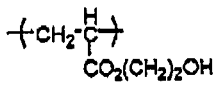 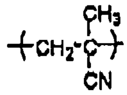 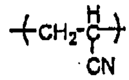

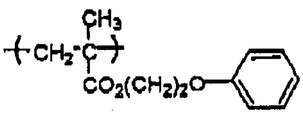 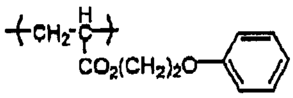 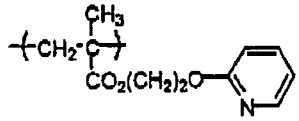

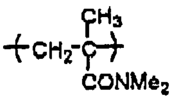 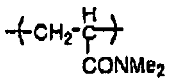 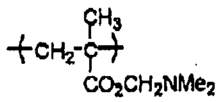 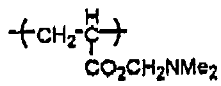

The resin (A) is a resin which contains a repeating unit represented by formula (I) capable of producing a carboxyl group of the side chain under the action of an acid and of which solubility in an alkali developer increases under the action of an acid (acid-decomposable resin), and preferably contains a group capable of decomposing under the action of an acid to produce an alkali-soluble group (acid-decomposable group), in an arbitrary repeating unit.

The acid-decomposable group may be contained also in other repeating units such as repeating unit represented by formula (A1) or (A2).

Examples of the acid-decomposable group include, in addition to those described above, a group represented by $-C(=O)-X_1-R_0$.

In the formula above, $R_0$ represents, for example, a tertiary alkyl group such as tert-butyl group and tert-amyl group, an isobornyl group, a 1-alkoxyethyl group such as 1-ethoxyethyl group, 1-butoxyethyl group, 1-isobutoxyethyl group and 1-cyclohexyloxyethyl group, an alkoxymethyl group such as 1-methoxymethyl group and 1-ethoxymethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group, or a mevalonic lactone residue. $X_1$ represents an oxygen atom, a sulfur atom, -NH-, $-NHSO_2-$ or $-NHSO_2NH-$.

The content of the acid-decomposable group-containing repeating unit in the resin (A) is preferably from 1 to 50 mol%, more preferably from 3 to 40 mol%, still more preferably from 5 to 30 mol%, based on all repeating units.

The content of the repeating unit represented by formula (I) in the resin (A) is preferably from 10 to 60 mol%, more preferably from 15 to 50 mol%, still more preferably from 20 to 40 mol%, based on all repeating units.

The content of the repeating unit represented by formula (A1) in the resin (A) is preferably from 40 to 90 mol%, more preferably from 50 to 85 mol%, still more preferably from 60 to 80 mol%, based on all repeating units.

The content of the repeating unit represented by formula (A2) in the resin (A) is preferably from 5 to 60 mol%, more preferably from 10 to 50 mol%, still more preferably from 15 to 35 mol%, based on all repeating units.

The resin (A) may further contain a repeating unit represented by formula (A4), and this is preferred from the standpoint of, for example, enhancing the film quality or suppressing the film loss in the unexposed area. The content of the repeating unit represented by formula (A4) is preferably from 0 to 50 mol%, more preferably from 0 to 40 mol%, still more preferably from 0 to 30 mol%, based on all repeating units.

In the resin (A), other appropriate polymerizable monomers may be copolymerized to introduce an alkali-soluble group such as phenolic hydroxyl group or carboxyl group for maintaining good developability with an alkali developer, or other hydrophobic polymerizable monomers such as alkyl acrylate or alkyl methacrylate may be copolymerized for enhancing the film quality.

The weight average molecular weight (Mw) of the resin (A) is preferably from 1,000 to 15,000, more preferably from 3,000 to 10,000. The dispersity (Mw/Mn) is preferably from 1.0 to 2.0, more preferably from 1.0 to 1.8, still more preferably from 1.0 to 1.5.

The weight average molecular weight here is defined as a polystyrene-reduced value determined by gel permeation chromatography.

The resin (A) having a dispersity of 1.5 to 2.0 can be synthesized by radical polymerization using an azo-based polymerization initiator. Also, the resin (A) having a still more preferred dispersity of 1.0 to 1.5 can be synthesized by living radical polymerization.

Two or more species of the resin (A) may be used in combination.

The amount of the resin (A) added is, as the total amount, usually from 10 to 96 mass%, preferably from 15 to 96 mass%, more preferably from 20 to 95 mass%, based on the entire solid content of the positive resist composition. (In this specification, mass ratio is equal to weight ratio.)

Specific examples of (A) the resin containing a repeating unit represented by formula (I) are set forth below, but the present invention is not limited thereto.

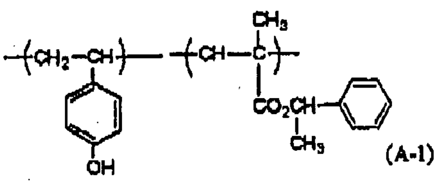
(A-1)

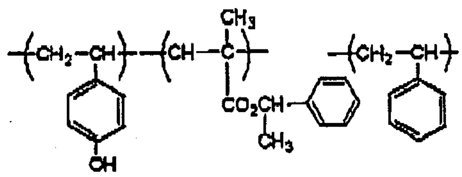
(A-2)

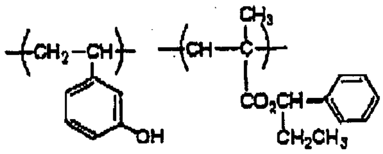
(A-3)

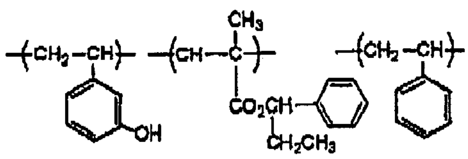
(A-4)

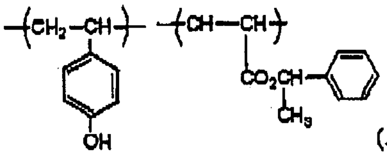
(A-5)

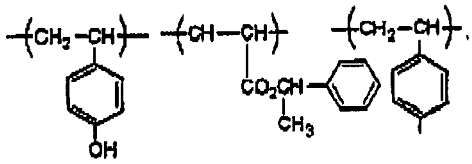
(A-6)

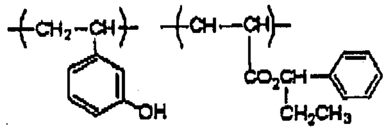
(A-7)

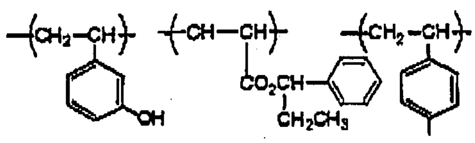
(A-8)

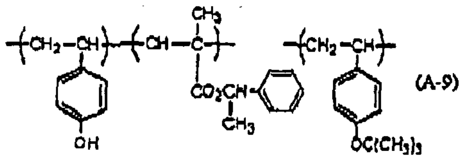 (A-9)

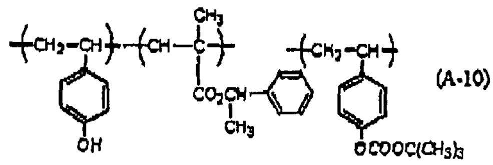 (A-10)

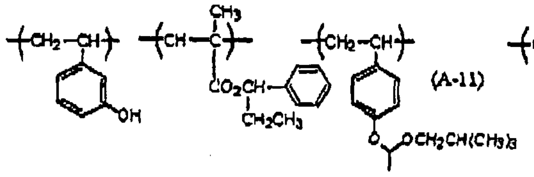 (A-11)

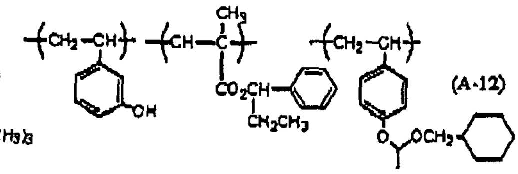 (A-12)

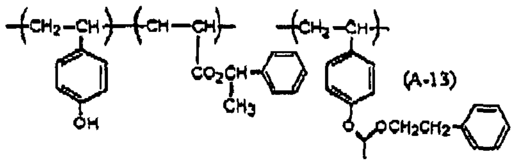 (A-13)

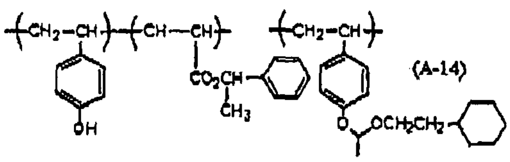 (A-14)

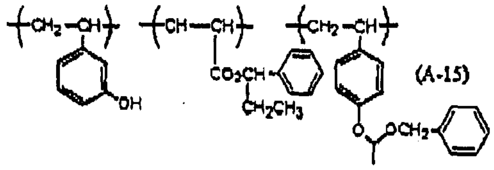 (A-15)

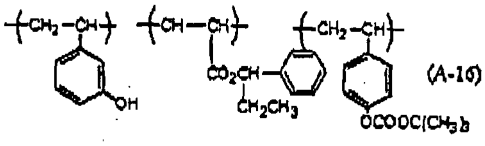 (A-16)

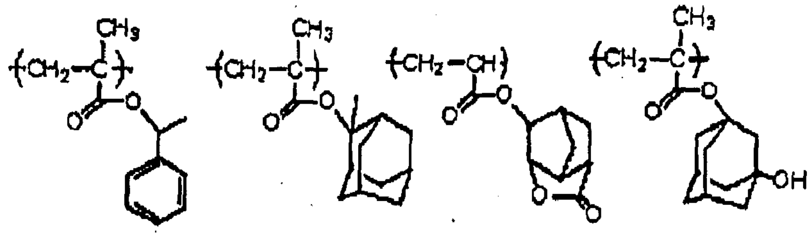 (A-17)

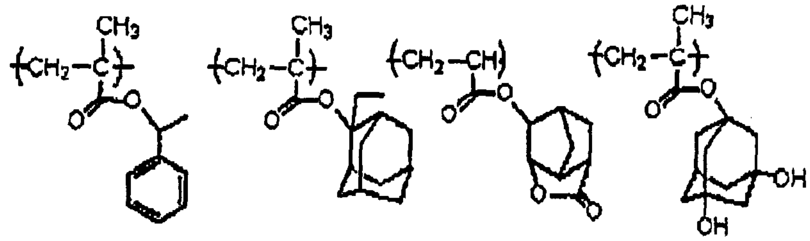 (A-18)

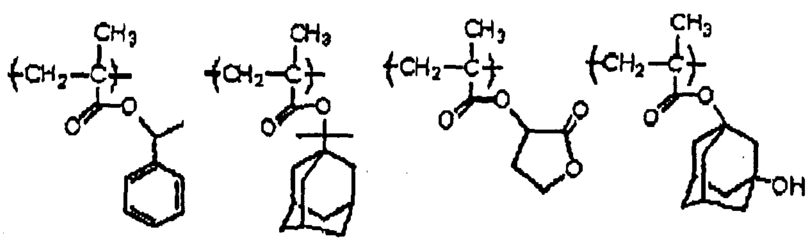 (A-19)

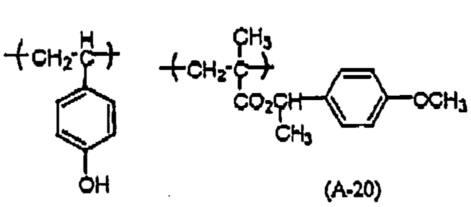

(A-20)

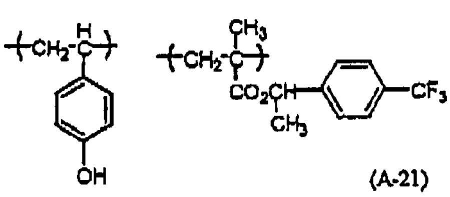

(A-21)

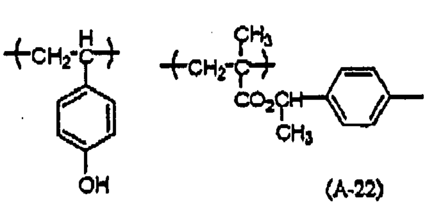

(A-22)

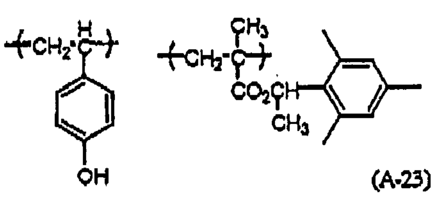

(A-23)

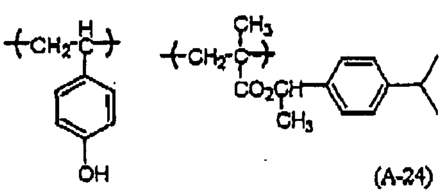

(A-24)

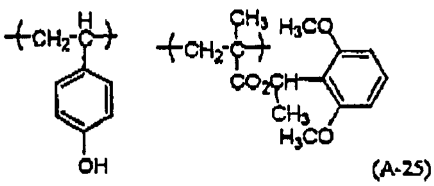

(A-25)

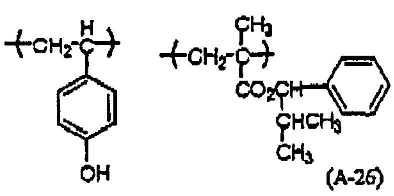

(A-26)

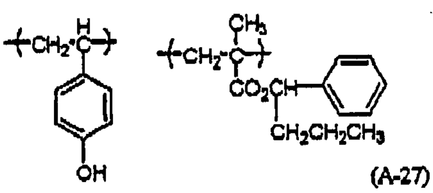

(A-27)

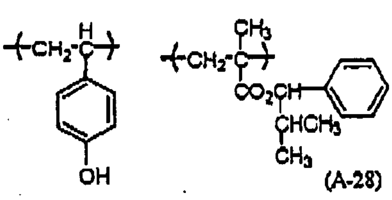

(A-28)

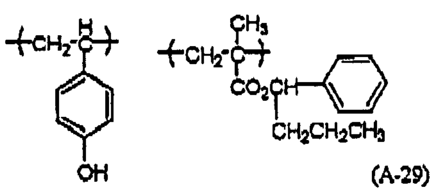

(A-29)

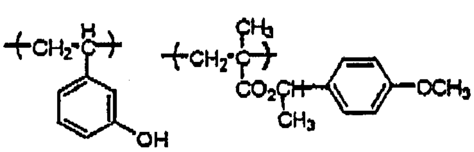

(A-30)

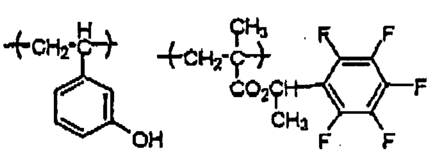

(A-31)

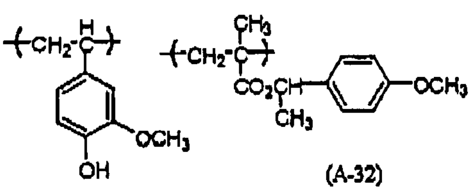

(A-32)

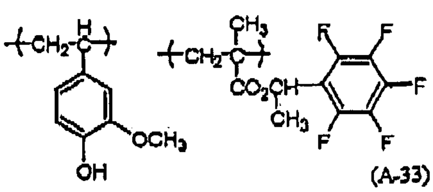

(A-33)

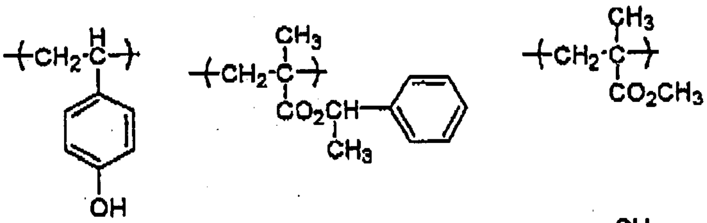
(A-34)

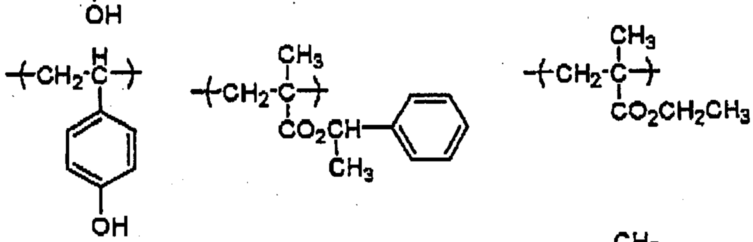
(A-35)

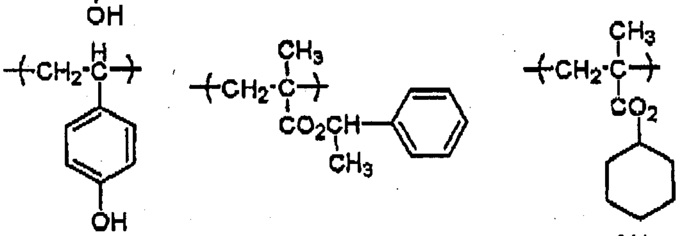
(A-36)

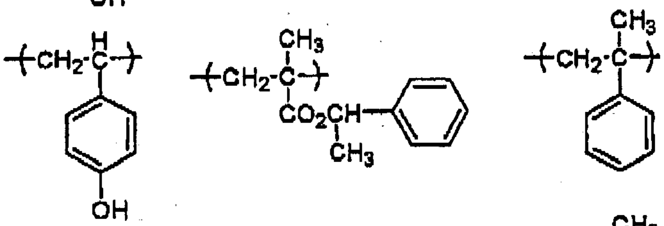
(A-37)

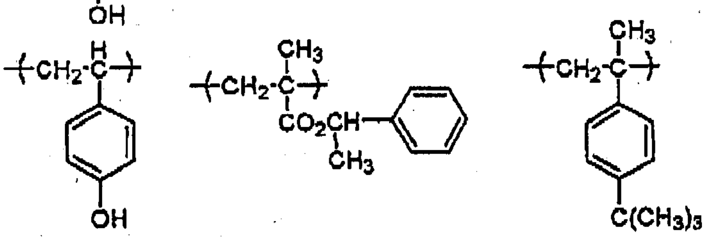
(A-38)

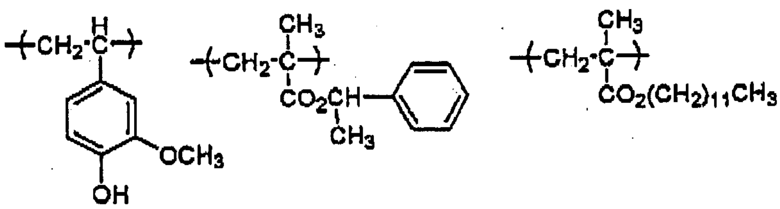
(A-39)

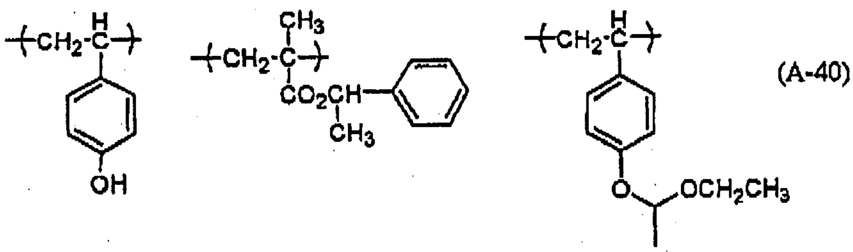
(A-40)

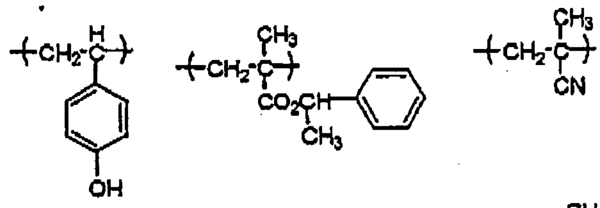
(A-41)

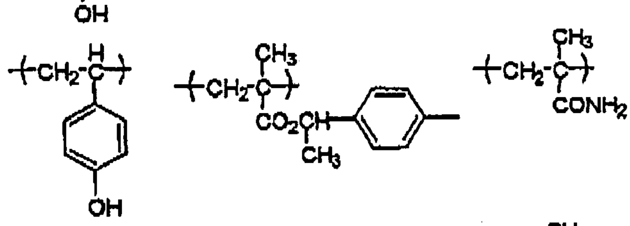
(A-42)

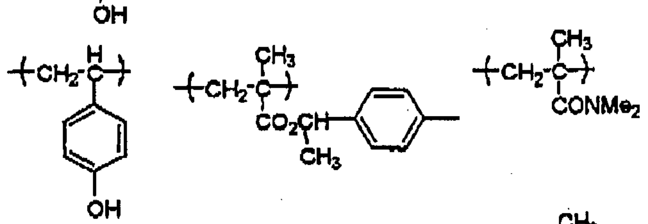
(A-43)

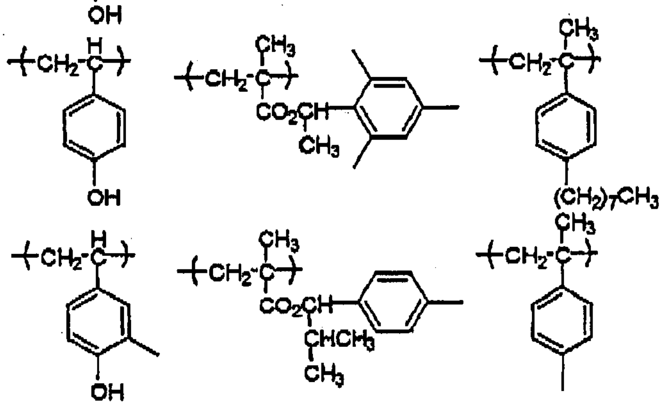
(A-44)

(A-45)

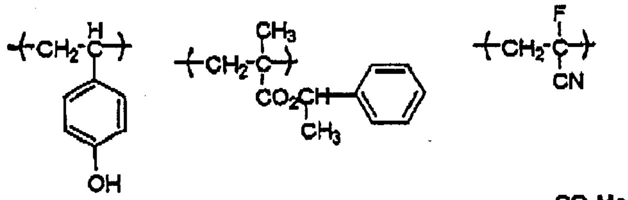
(A-46)

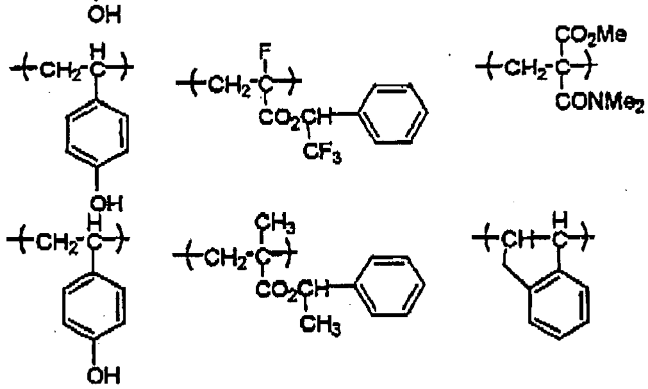
(A-47)

(A-48)

In the case of irradiating KrF excimer laser light, X ray or high-energy beam at a wavelength of 50 nm or less (e.g., EUV), the positive photosensitive composition of the present invention preferably contains a hydroxystyrene copolymer protected by hydroxystyrene/acid-decomposable group, or a hydroxystyrene/tertiary alkyl (meth)acrylate copolymer.

Specific examples thereof are set forth below, but the present invention is not limited thereto.

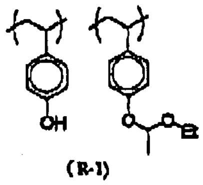

(R-1)

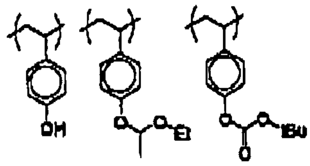

(R-2)

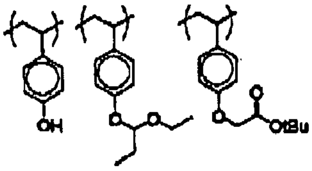

(R-3)

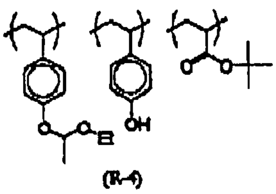

(R-4)

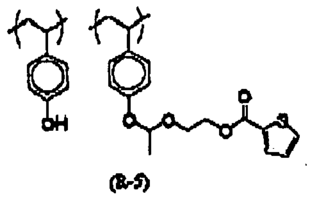

(R-5)

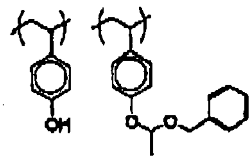

(R-6)

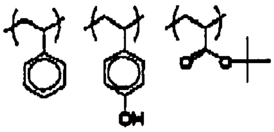

(R-7)

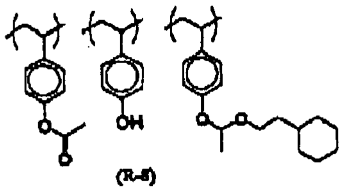

(R-8)

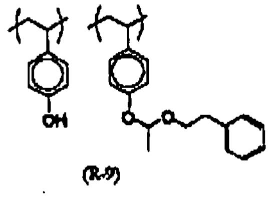

(R-9)

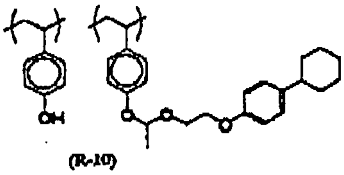

(R-10)

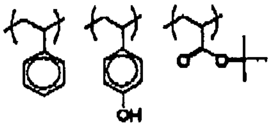

(R-11)

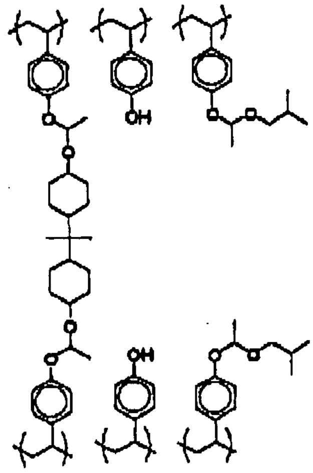

(R-12)

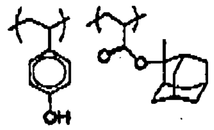

(R-13)

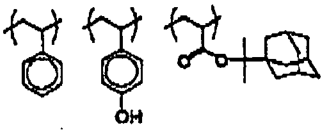

(R-14)

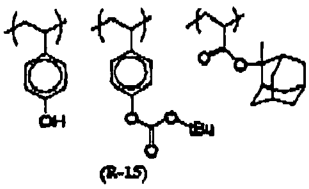

(R-15)

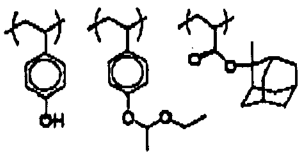

(R-16)

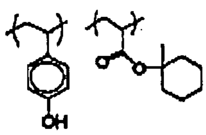

(R-17)

In these specific examples, "tBu" indicates a tert-butyl group.

The content of the group capable of decomposing under the action of an acid is expressed by B/(B+S) using the number (B) of acid-decomposable groups in the resin and the number (S) of alkali-soluble groups not protected by a group which desorbs by the effect of an acid. The content is preferably from 0.01 to 0.7, more preferably from 0.05 to 0.50, still more preferably from 0.05 to 0.40.

[2] Compound capable of generating acid upon irradiation with actinic rays or radiation

In the resist composition of the present invention, a known compound may be used as the compound capable of generating an acid upon irradiation with actinic rays or radiation (acid generator), but a compound capable of generating a sulfonic acid upon irradiation with actinic rays or radiation (sulfonic acid generator) and/or a compound capable of generating a carboxylic acid upon irradiation with actinic rays or radiation (carboxylic acid generator) are preferably contained.

<Compound (B) capable of generating sulfonic acid upon irradiation with actinic rays or radiation>

The compound capable of generating a sulfonic acid upon irradiation with actinic rays or radiation (sometimes referred to as a "compound (B)" or a "sulfonic acid generator"), which is contained in the resist composition of the present invention, is a compound capable of generating a sulfonic acid upon irradiation with actinic rays or radiation such as KrF excimer laser, electron beam and EUV, and examples thereof include a diazonium salt, a phosphonium salt, a sulfonium salt, an iodonium salt, an imidosulfonate, an oxime sulfonate, a diazodisulfone, a disulfone and an o-nitrobenzylsulfonate.
Also, a compound where such a group or compound capable of generating an acid upon irradiation with actinic rays or radiation is introduced into the main or side chain of a polymer may be used, and examples thereof include the compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.
Furthermore, compounds capable of generating an acid by the effect of light described, for example, in U.S. Patent 3,779,778 and European Patent 126,712 may also be used.
In the present invention, from the standpoint of enhancing the image performance such as resolving power and pattern profile, a sulfonium salt, an iodonium salt, an imidosulfonate, an oxime sulfonate, a diazodisulfone and a disulfone are preferred as the sulfonic acid generator.
Particularly preferred examples of these compounds set forth below.

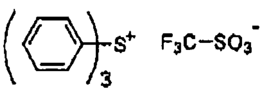
B-1

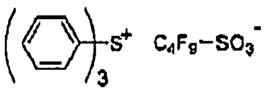
B-2

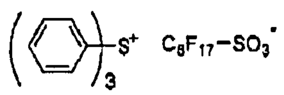
B-3

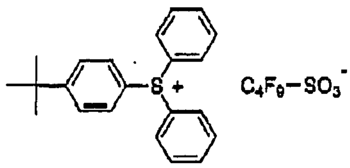
B-4

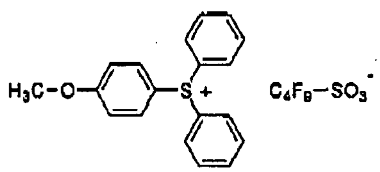
B-5

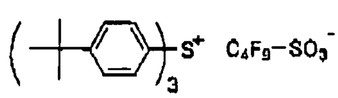
B-6

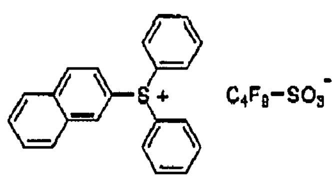
B-7

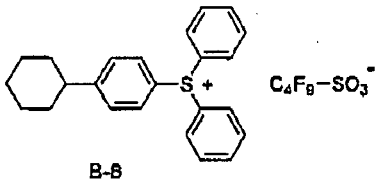

B-8

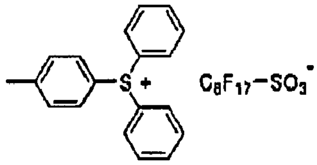

B-9

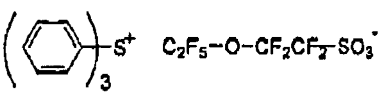

B-10

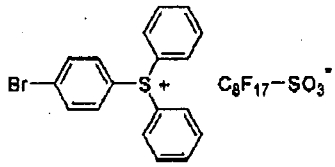

B-11

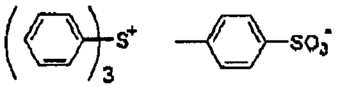

B-12

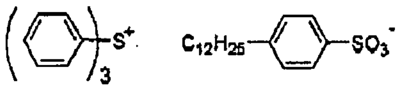

B-13

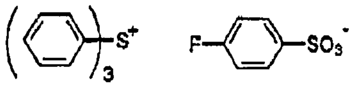

B-14

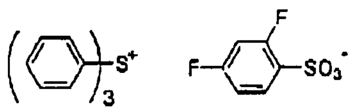

B-15

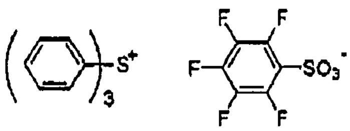

B-16

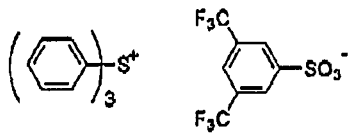

B-17

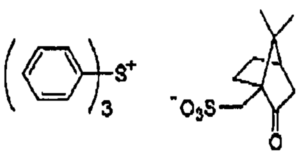

B-18

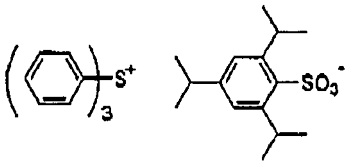

B-19

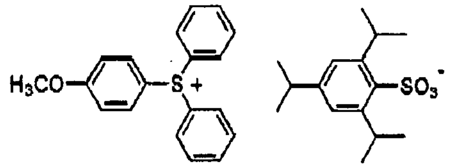

B-20

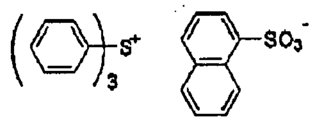

B-21

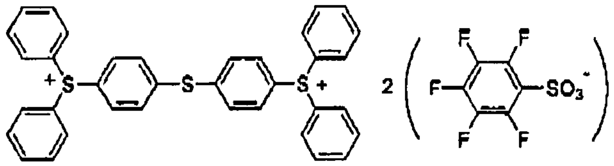

B-22

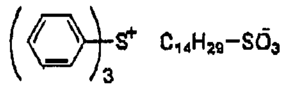

B-23

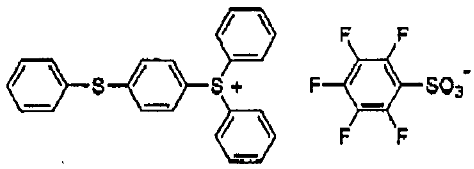

B-24

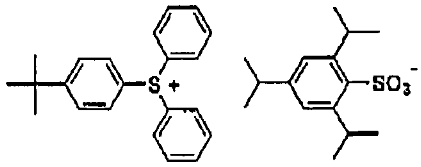

B-25

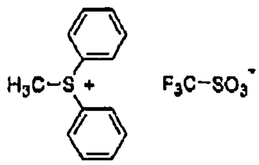

B-26

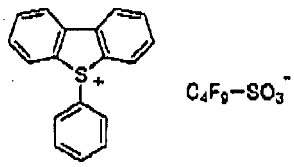

B-27

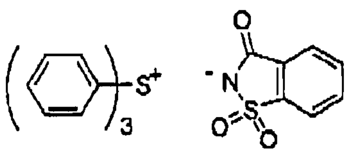

B-28

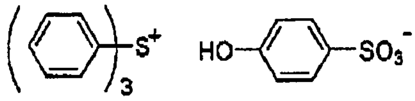

B-29

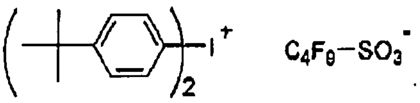

B-30

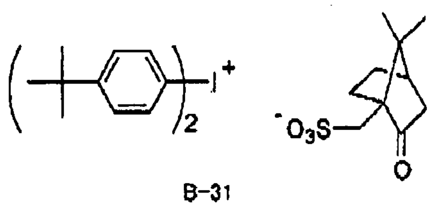

B-31

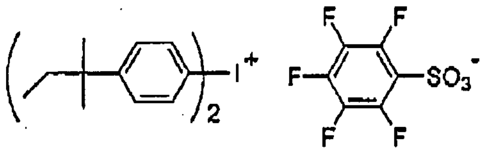

B-32

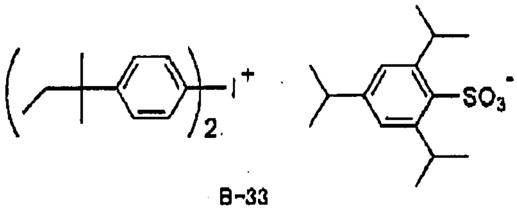

B-33

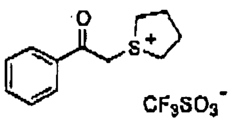

B-34

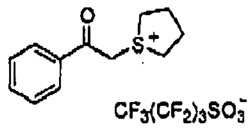

B-35

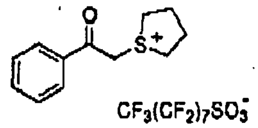

B-36

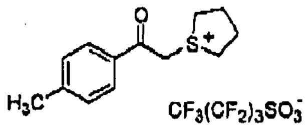

B-37

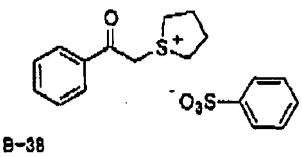

B-38

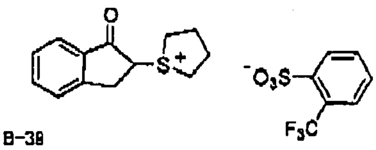

B-39

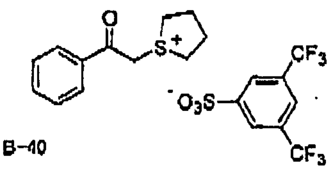

B-40

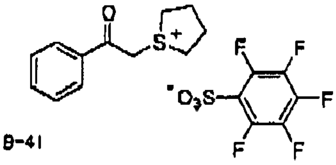

B-41

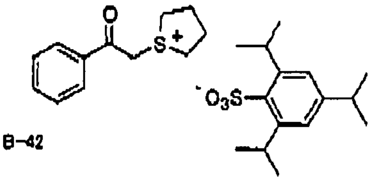

B-42

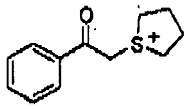
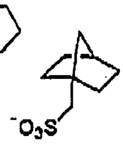

B-43

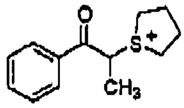

$CF_3(CF_2)_3SO_3^-$

B-44

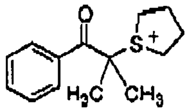

B-45 $CF_3(CF_2)_3SO_3^-$

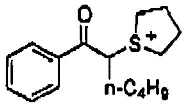

$CF_3(CF_2)_3SO_3^-$

B-46

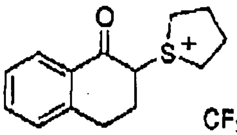

$CF_3(CF_2)_3SO_3$

B-47

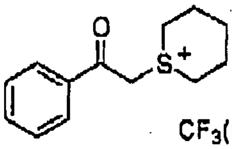

$CF_3(CF_2)_3SO_3^-$

B-48

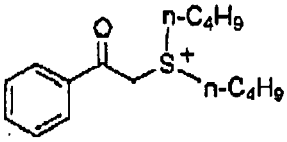

$CF_3(CF_2)_3SO_3^-$

B-49

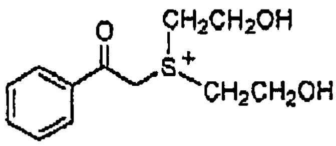
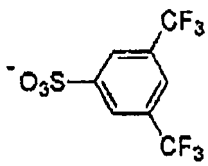

B-50

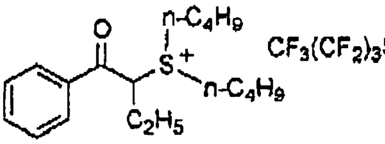

$CF_3(CF_2)_3SO_3^-$

B-51

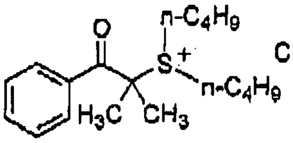

$CF_3(CF_2)_3SO_3^-$

B-52

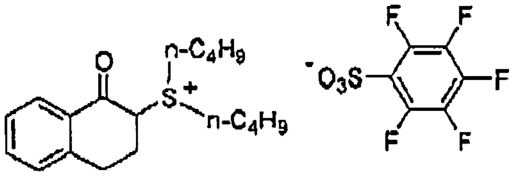

B-53

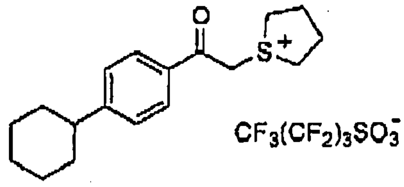

B-54

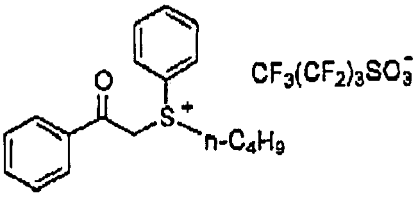

B-55

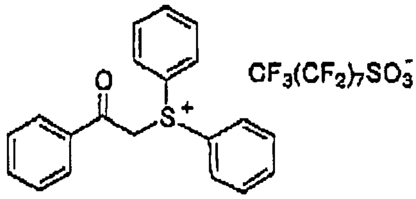

B-56

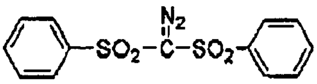

B-57

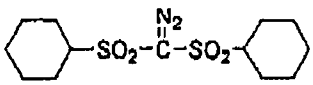

B-58

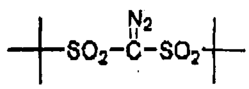

B-59

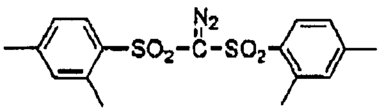

B-60

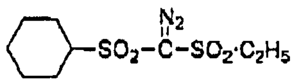

B-61

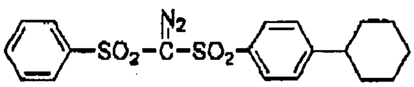

B-62

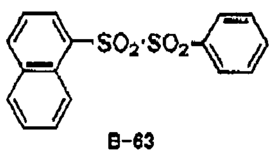

B-63

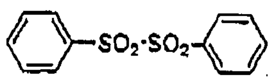

B-64

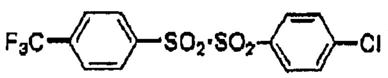

B-65

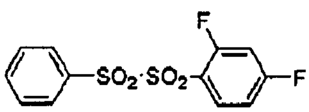

B-66

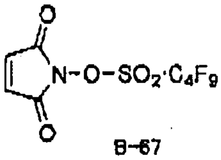

B-67

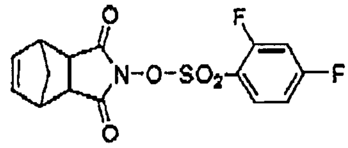

B-68

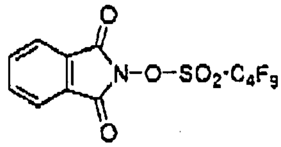

B-69

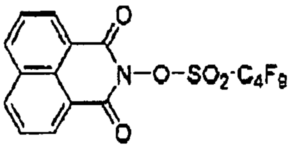

B-70

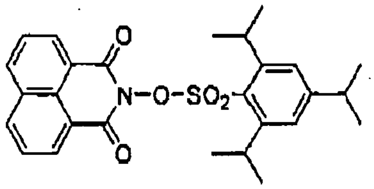

B-71

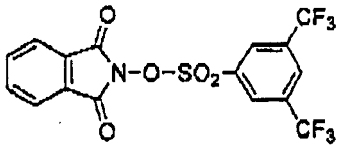

B-72

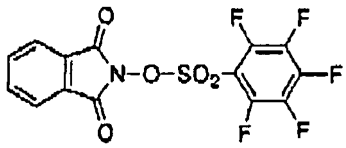

B-73

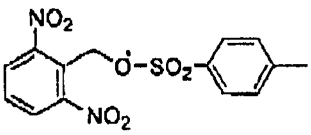

B-74

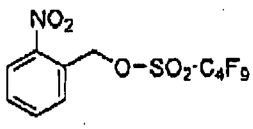

B-75

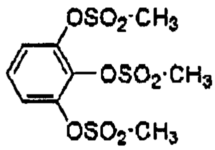

B-76

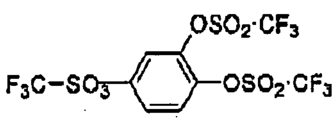

B-77

B-78

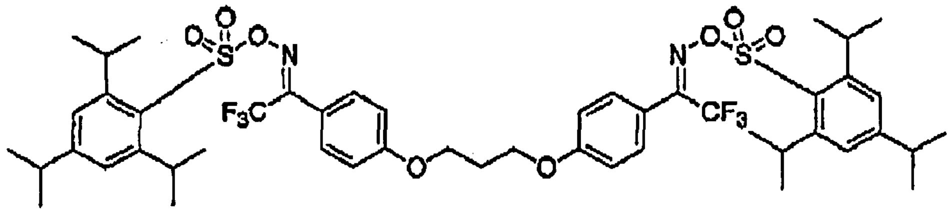

B-79

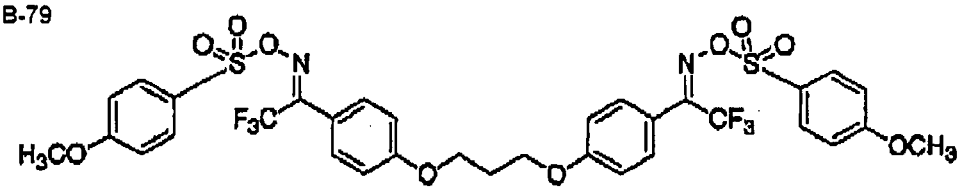

B-80

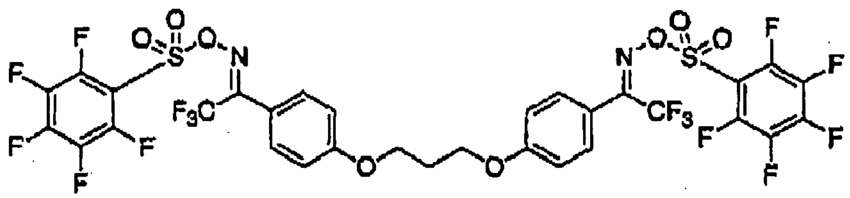

B-81

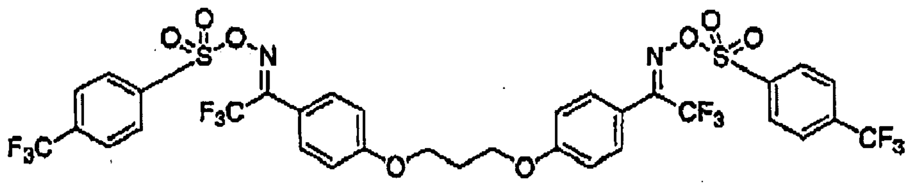

B-82

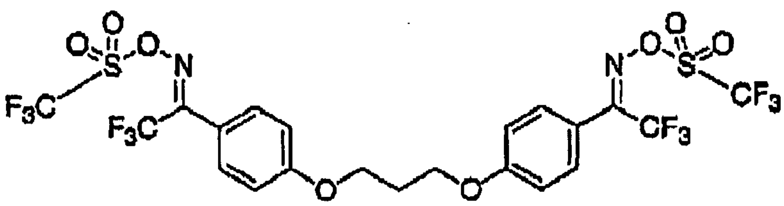

B-83

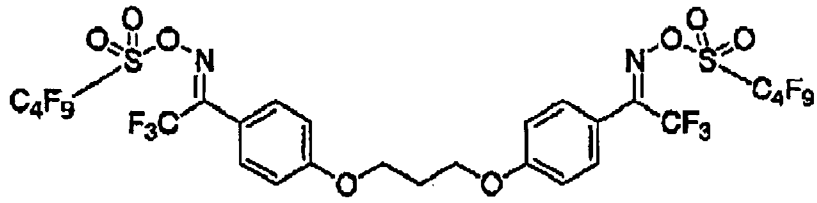

The content of the compound (B) is from 5 to 20 mass%, preferably from 6 to 18 mass%, more preferably from 7 to 16 mass%, based on the entire solid content of the resist composition. The content is 5 mass% or more in view of sensitivity or line edge roughness and 20 mass% or less in view of resolving power, pattern profile and film quality. One species of the compound (B) may be used, or a mixture of two or more species thereof may be used. For example, a compound capable of generating an arylsulfonic acid upon irradiation with actinic rays or radiation and a compound capable of generating an alkylsulfonic acid upon irradiation with actinic rays or radiation may be used in combination as the compound (B).
The compound (B) can be synthesized by a known method such as synthesis method described in JP-A-2002-27806.

<Compound (C) capable of generating a carboxylic acid upon irradiation with actinic rays or radiation>

In the positive resist composition of the present invention, a compound capable of generating a carboxylic acid upon irradiation with actinic rays or radiation (sometimes referred to as a "compound (C)" or a "carboxylic acid generator") may be used.
The carboxylic acid generator is preferably a compound represented by the following formula (C):

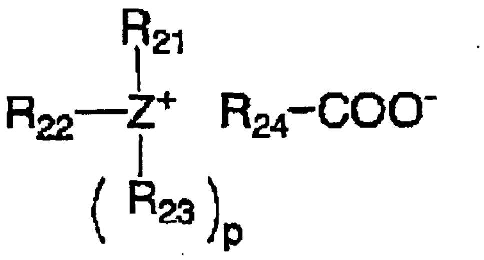 (C)

In formula (C), $R_{21}$ to $R_{23}$ each independently represents an alkyl group, a cycloalkyl group, an alkenyl group or an aryl group, $R_{24}$ represents a hydrogen atom, an alkyl group, a cycloalkyl group, an alkenyl group or an aryl group, and Z represents a sulfur atom or an iodine atom, When Z is a sulfur atom, p is 1, and when Z is an iodine atom, p is 0.
In formula (C), $R_{21}$ to $R_{23}$ each independently represents an alkyl group, a cycloalkyl group, an alkenyl group or an aryl group, and these groups each may have a substituent.
Examples of the substituent which the alkyl group, cycloalkyl group and alkenyl group may have include a halogen atom (e.g., chlorine, bromine, fluorine), an aryl group (e.g., phenyl, naphthyl), a hydroxy group and an alkoxy group (e.g., methoxy, ethoxy, butoxy).
Examples of the substituent which the aryl group may have include a halogen atom (e.g., chlorine, bromine, fluorine), a nitro group, a cyano group, an alkyl group (e.g., methyl, ethyl, tert-butyl, tert-amyl, octyl), a hydroxy group and an alkoxy group (e.g., methoxy, ethoxy, butoxy).
$R_{21}$ to $R_{23}$ each is independently preferably an alkyl group having a carbon number of 1 to 12, a cycloalkyl group having a carbon number of 3 to 12, an alkenyl group having a carbon number of 2 to 12 or an aryl group having a carbon number of 6 to 24, more preferably an alkyl group having a carbon number of 1 to 6, a cycloalkyl group having a carbon number of 3 to 6 or an aryl group having a carbon number of 6 to 18, still more preferably an aryl group having a carbon number of 6 to 15, and these groups each may have a substituent.
$R_{24}$ represents a hydrogen atom, an alkyl group, a cycloalkyl group, an alkenyl group or an aryl group.
Examples of the substituent which the alkyl group, cycloalkyl group and alkenyl group may have are the same

as those of the substituent described above when $R_{21}$ is an alkyl group. Examples of the substituent for the aryl group are the same as those of the substituent described above when $R_{21}$ is an aryl group.

$R_{24}$ is preferably a hydrogen atom, an alkyl group having a carbon number of 1 to 30, a cycloalkyl group having a carbon number of 3 to 30, an alkenyl group having a carbon number of 2 to 30 or an aryl group having a carbon number of 6 to 24, more preferably an alkyl group having a carbon number of 1 to 18, a cycloalkyl group having a carbon number of 3 to 18 or an aryl group having a carbon number of 6 to 18, still more preferably an alkyl group having a carbon number of 1 to 12, a cycloalkyl group having a carbon number of 3 to 12 or an aryl group having a carbon number of 6 to 15. These groups each may have a substituent.

Z represents a sulfur atom or an iodine atom. p is 1 when Z is a sulfur atom, and 0 when Z is an iodine atom.

Incidentally, two or more cation moieties of formula (C) may combine through a single bond or a linking group (e.g., -S-, -O-) to form a cation structure having a plurality of cation moieties of formula (C).

Specific preferred examples of the compound (C) capable of generating a carboxylic acid upon irradiation with actinic rays or radiation are set forth below, but the present invention is of course not limited thereto.

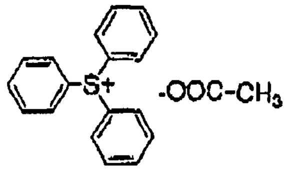

C-1

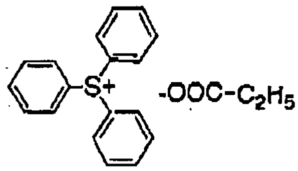

C-2

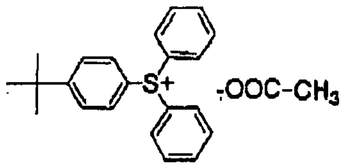

C-3

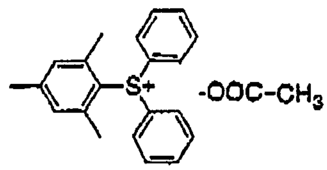

C-4

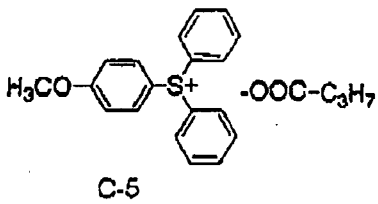

C-5

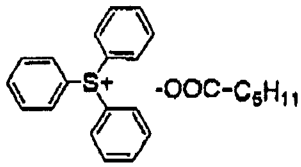

C-6

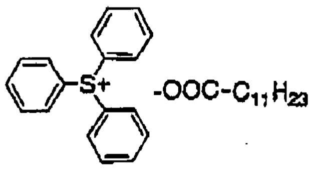

C-7

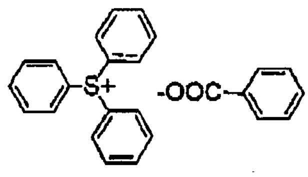

C-8

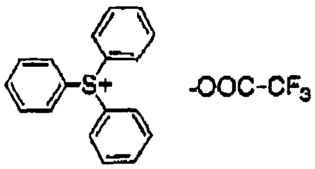

C-9

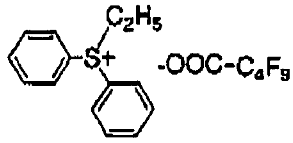

C-10

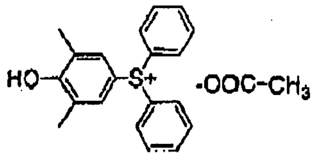

C-11

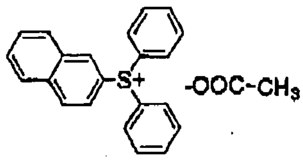

C-12

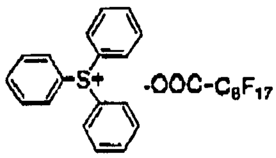

C-13

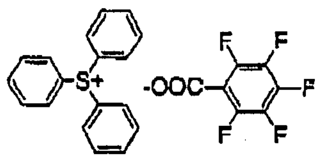

C-14

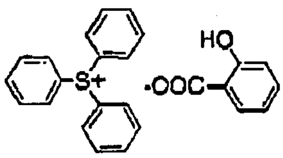

C-15

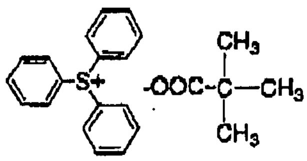

C-16

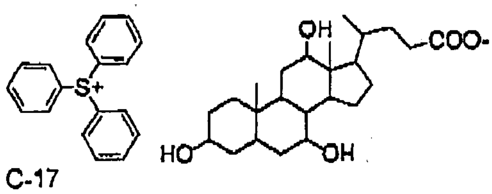

C-17

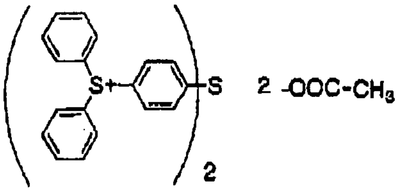

C-18

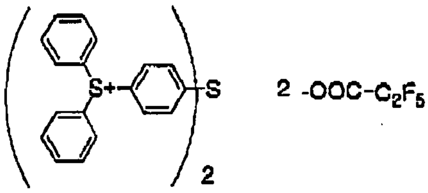

C-19

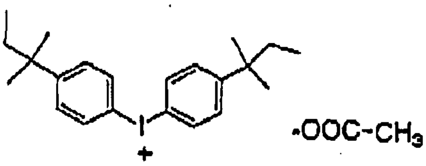

C-20

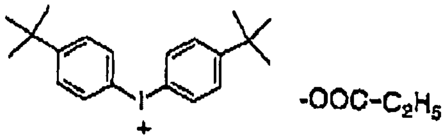

C-21

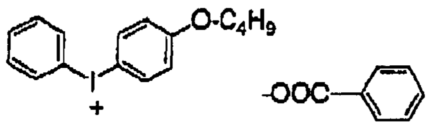

C-22

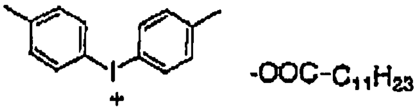

C-23

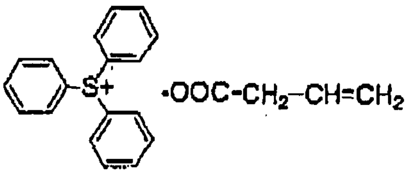

C-24

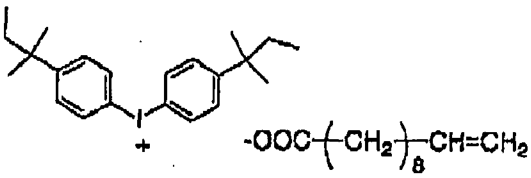

C-25

The content of the compound (C) in the positive resist composition of the present invention is preferably from 0.01 to 10 mass%, more preferably from 0.03 to 5 mass%, still more preferably from 0.05 to 3 mass%, based on the entire solid content of the composition. One species of the compound capable of generating a carboxylic acid upon irradiation with actinic rays or radiation may be used, or a mixture of two or more species thereof may be used. The compound (C) can be synthesized by a known method such as synthesis method described in JP-A-2002-27806.

In the present invention, a sulfonic acid generator (compound (B)) is preferred, and a combination use of a sulfonic acid generator (compound (B)) and a carboxylic acid generator (compound (C) is more preferred.

The compound (C)/compound (B) (ratio by mass) is usually from 99.9/0.1 to 50/50, preferably from 99/1 to 60/40, more preferably from 98/2 to 70/30.

[3] Tertiary Amine Compound

The resist composition of the present invention comprises a tertiary amune compound. The molecular weight

of the tertiary amine compound is generally from 50 to 1,000, preferably from 100 to 500.

The preferred structure of the tertiary amine compound includes a structure represented by formula (II):

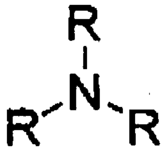

(II)

In formula (II), three R's may be the same or different and each represents a linear or branched alkyl or cycloalkyl group having a carbon number of 1 to 20, which may contain a hydroxyl group, an ether group, a carbonyl group, an ester group, a lactone group, a carbonate group or a cyano group. Preferably, at least one of the three R's is a cycloalkyl group. A structure where R's are the same and each has a carbon number of 6 to 16 or two R's are a cycloalkyl group is more preferred, a structure where R's are the same and each has a carbon number of 8 to 12 or where two R's are a cyclohexyl group is even more preferred, and a structure where R's are the same and each has a carbon number of 12 or where two R's are a cycloalkyl group and one R is a methyl group is particularly more preferred. A structure where two R's are a cyclohexyl group and one R is a methyl group is most preferred.

The tertiary amine compound decreases the solubility of the resist film surface in the unexposed area by inhibiting the deprotection of the paltry exposed area in the unexposed area and yields an excellent side lobe margin.

Specific examples of the tertiary amine compound represented by formula (II) are set forth below, but the present invention is not limited to these specific examples.

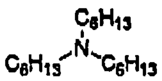
D-1
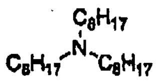
D-2
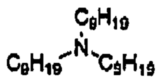
D-3
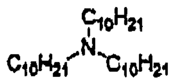
D-4
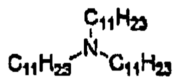
D-5

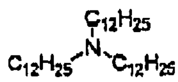
D-6
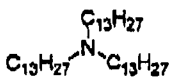
D-7
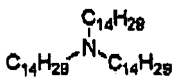
D-8
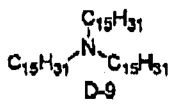
D-9
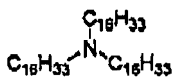
D-10

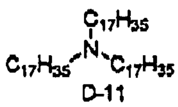
D-11
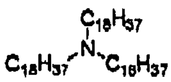
D-12
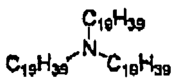
D-13
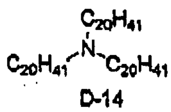
D-14
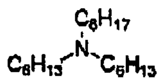
D-15

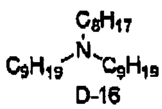
D-16
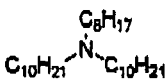
D-17
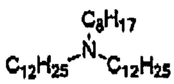
D-18
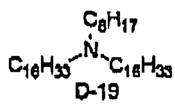
D-19
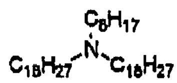
D-20

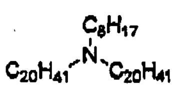
D-21
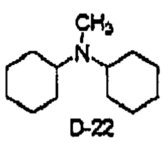
D-22
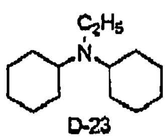
D-23
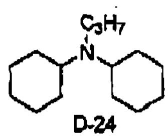
D-24
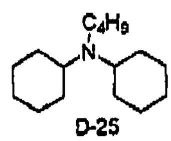
D-25

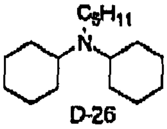
D-26

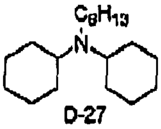
D-27

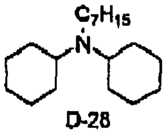
D-28

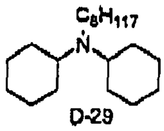
D-29

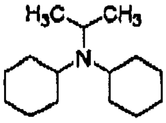
D-30

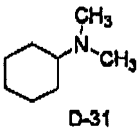
D-31

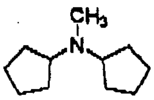
D-32

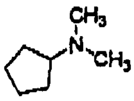
D-33

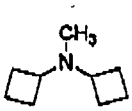
D-34

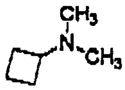
D-35

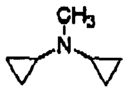
D-36

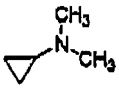
D-37

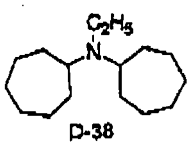
D-38

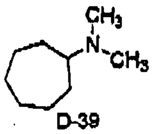
D-39

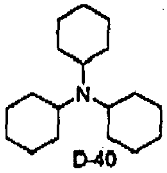
D-40

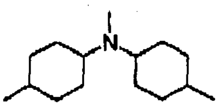
D-41

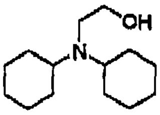
D-42

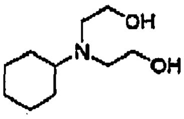
D-43

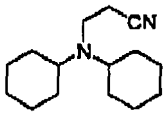
D-44

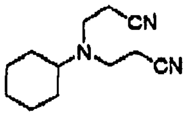
D-45

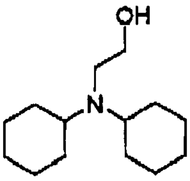
D-46

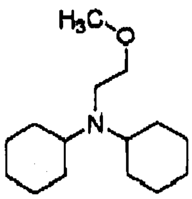
D-47

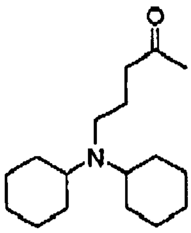
D-48

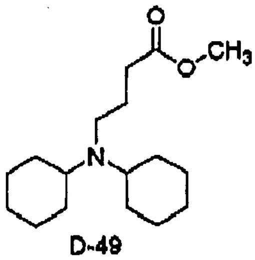
D-49

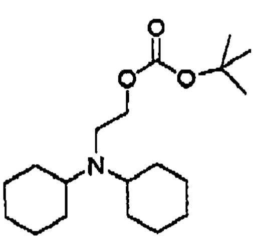
D-50

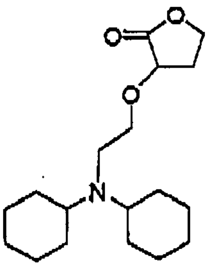
D-51

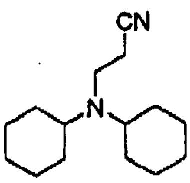
D-52

The tertiary amine compound for use in the present invention may be a commercially available product or may be synthesized by a known method.

The amount of the tertiary amine compound added is generally from 0.01 to 10 mass%, preferably from 0.05 to 5 mass%, based on the entire solid content of the resist composition.

In addition to the tertiary amine compound of the present invention, one species or two or more species of other basic compounds which have been conventionally employed may be used in combination. Examples of the other basic compound include primary and secondary aliphatic amines, mixed amines, aromatic amines, heterocyclic amines, nitrogen-containing compounds having a carboxyl group, nitrogen-containing compounds having a sulfonyl group, nitrogen-containing compounds having a hydroxyl group, nitrogen-containing compounds having a hydroxyphenyl group, alcoholic nitrogen-containing compounds, amide derivatives and imide derivatives.

The amount of the other basic compound added is preferably 500 mass% or less, more preferably 200 mass% or less, based on the tertiary amine compound.

Examples of the primary aliphatic amines include ammonia, methylamine, ethylamine, n-propylamine, isopropylamine, n-butylarnine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine and tetraethylenepentamine.

Examples of the secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dirnethylethylenediamine and N,N-dimethyltetraethylenepentamine.

Examples of the mixed amines include dimemylethylamine, methylethylpropylamine, benzylamine, phenethylamine and benzyldimethylamine.

Specific examples of the aromatic amines and heterocyclic amines include an aniline derivative (e.g., aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, N,N-bis(2-hydroxyethyl)aniline, 4-methyl N,N-bis(2-hydroxyethyl)anilin,e), a diphenyl(p-tolyl)amine, a methyldiphenylamine, a triphenylamine, a phenylenediamine, a naphthylamine, a diaminonaphthalene, a pyrrole derivative (e.g., pyrrole, 2H-pyrrole, 1-methylpyrrole, 2,4-dimethylpyrrole, 2,5-dimethylpyrrole, N-methylpyrrole), an oxazole derivative (e.g., oxazole, isoxazole), a thiazole derivative (e.g., thiazole, isothiazole), an imidazole derivative (e.g., imidazole, 4-methylimidazole, 4-methyl-2-phenylimidazole), a pyrazole derivative, a furazan derivative, a pyrroline derivative (e.g., pyrroline, 2-methyl-1-pyrroline), a pyrrolidine derivative (e,g., pyrrolidine, N-methylpyrrolidizte, pyrrolidinone, N-methylpyrrolidone), an imidazoline derivative, an imidazolidine derivative, a pyridine derivative (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine), a pyridazine derivative, a pyrimidine derivative, a pyrazine derivative, a pyrazoline derivative, a pyrazolidine derivative, a piperidine derivative, a piperazine derivative, a morpholine derivative, an indole derivative, an isoindole derivative, a 1H-indazole derivative, an indoline derivative, a quinoline derivative (e.g., quinoline, 3-quinolinecarbonitrile), an isoquinoline derivative, a cinnoline derivative, a quinazoline derivative, a quinoxaline derivative, a phthalazine derivative, a purine derivative, a pteridine derivative, a carbazole derivative, a phenanthridine derivative, an acridine derivative, a phenazine derivative, a 1,10-phenanthroline derivative, an adenine derivative, an adenosine derivative, a guanine derivative, a guanosine derivative, a uracil derivative and a uridine derivative.

Examples of the nitrogen-containing compound having a carboxyl group include an aminobenzoic acid, an indolecarboxylic acid and an amino acid derivative (e.g., nicotinic acid, alanine, arginine, aspartic acid, glutamic acid, glycine, histidine, isoleucine, glycylleucine, leucine, methionine, phenylalanine, threonine, lysine, 3-aminopyrazine-2-carboxylic acid, methoxyalanine).

Examples of the nitrogen-containing compound having a sulfonyl group include 3-pyridinesulfonic acid and pyridinium p-toluenesulfonate.

Examples of the nitrogen-containing compound having a hydroxyl group, nitrogen-containing compound having a hydroxyphenyl group, and alcoholic nitrogen-containing compound include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy) ethyl]piperazine, piperidine ethanol, 1-(2-hydroxyethyl)pyrrolidine, 1-(2-hydraxyethyl)-2-pyrrolidinone, 3-piperidano-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide and N-(2-hydroxyethyl)isonicotinamide.

Examples of the amide derivative include formamide, N-methylformamide, N,N-dimethylformamide, acetamide, N-methylacetarnxde, N,N-dimethylacetamide, propionamide and benzamide. Examples of the imide derivative include phthalimide, succinimide and maleimide.

A tetraalkylammonium salt-type nitrogen-containing basic compound may also be used. Among such compounds, a tetraa1kylammonium hydroxide having a carbon number of 1 to 8 (e.g., tetramethylammonium hydroxide, tetraethylammonium hydroxide, tetra-(n-butyl)ammonium hydroxide) is preferred. One of these nitrogen-containing basic compounds may be used alone, or two or more species thereof may be used in combination.

As for the ratio between the acid generator and the organic basic compound including the tertiary amine compound, used in the composition, the (total amount of acid generator)/(organic basic compound) (molar ratio) is preferably from 2.5 to 300. By setting this molar ratio to 2.5 or more, high sensitivity can be obtained and by setting the molar ratio to 300 or less, the resist pattern can be prevented from thickening in aging after exposure until heat treatment and the resolving power can be enhanced. The (total amount of acid generator)/(organic basic compound) (molar ratio) is more preferably from 5.0 to 200, still more preferably from 7.0 to 150.

[4] Surfactants

In the present invention, surfactants can be used and use thereof is preferred in view of film-forming property, adhesion of pattern and reduction in development deficiency.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303 and EF352 (produced by Shin-Akita Chemical Co., Ltd.), Megafac F171 and F173 (produced by Dainippon Ink & Chemicals, Inc.), Florad FC430 and FC431 (produced by Sumitomo 3M Inc.), Asahiguard AG710, Surflon S-382, SC101, SC102, SC103, SC104, SC105 and SC106 (produced by Asahi Glass Co., Ltd.), and Troysol S-366 (produced by Troy Chemical Industries, Inc.); an organosiloxane polymer, KP-341 (produced by Shin-Etsu Chemical Co., Ltd.); and acrylic acid-based or methacrylic acid-based (co)polymers, Polyflow No. 75 and No. 95 (produced by Kyoeisha Yushi Kagaku Kogyo Co., Ltd.). The blending amount of such a surfactant is usually 2 parts by mass or less, preferably 1 part by mass or less, per 100 parts by mass of the solid content in the composition of the present invention.

One of these surfactants may be used alone or several species thereof may be added in combination.

As for the surfactant, the composition preferably contains any one species of fluorine- and/or silicon-containing surfactants (a fluorine-containing surfactant, a silicon-containing surfactant or a surfactant containing both a fluorine atom and a silicon atom), or two or more species thereof.

Examples of these surfactants include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, a polysiloxane polymer, KP-341 (produced by Shin-Etsu Chemical Co., Ltd.), may also be used as the silicon-containing surfactant.

Other than these known surfactants, a surfactant using a polymer having a fluoroaliphatic group which is derived from a fluoroaliphatic compound produced by a telomerization process (also called a telomer process) or an oligomerization process (also called an oligomer process), may be used. The fluoroaliphatic compound can be synthesized by the method described in JP-A-2002-90991.

The polymer having a fluoroaliphatic group is preferably a copolymer of a fluoroaliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoroaliphatic group-containing monomer with a (poly(oxyalkylene)) acrylate (or methacrylate) may be not only a binary copolymer but also a ternary or higher copolymer obtained by simultaneously copolymerizing two or more different fluoroaliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a $C_6F_{13}$ group-containing acrylate (or methacrylate) with a (poly(oxyalkylane)) acrylate (or methacrylate), a copolymer of a $C_6F_{13}$ group-containing acrylate (or methacrylate) with (poly(oxyethylene)) acrylate (or methacrylate) and (poly(oxypropylene)) acrylate (or methacrylate), a copolymer of a $C_8F_{17}$ group-containing acrylate (or methacrylate) with a (poly(oxyalkylene)) acrylate (or methacrylate), and a copolymer of a $C_8F_{17}$ group-containing acrylate (or methacrylate) with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the positive resist composition (excluding the solvent).

[5] Other components

The positive resist composition of the present invention may further contain, if desired, a dye, a photobase generator and the like.

1. Dye

In the present invention, a dye may be used.

The suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

2. Photobase generator

Examples of the photobase generator which can be added to the composition of the present invention include the compounds described in JP-A-4-151156, JP-A-4-162040, JP-A-S-197148, JP-A-5-5995, JP-A-6-194834, JP-A-8-146608, JP-A-10-83079 and European Patent 622,682. Specific examples of the photobase generator which can be suitably used include 2-nitrobenzyl carbamate, 2,5-dinitrobenzylcyclohexyl carbamate, N-cyclohexyl-4-methylphenylsulfonamide and 1,1-dimethyl-2-phenylethyl-N-isopropyl carbamate. Such a photobase generator is added for the purpose of improving the resist profile or the like.

3. Solvents

The resist composition of the present invention is dissolved in a solvent capable of dissolving respective components described above and then coated on a support. Usually, the resist composition is preferably dissolved to a concentration of, in terms of the solid content concentration of all resist components, from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or some are used as a mixture.

The positive resist composition of the present invention is coated on a substrate to form a thin film. The thickness of this coating film is preferably from 0.05 to 4.0 μm.

In the present invention, a commercially available inorganic or organic antireflection film may be used, if desired. Furthermore, the antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative/formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film containing a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising a methylolmelamine and a benzophenone-based light absorbent described in JP-A-8-87115, and a film obtained by adding a low molecular light absorbent to a polyvinyl

alcohol resin described in JP-A-8-179509.

Also, the organic antireflection film may be a commercially available organic antireflection film such as DUV-30 Series and DLTV-40 Series produced by Brewer Science, Inc.; and AR-2, AR-3 and AR-5 produced by Shipley Co., Ltd,

In the production or the like of a precision integrated circuit device, the step of forming a pattern on a resist film is performed by coating the positive resist composition of the present invention on a substrate (for example, a silicon/silicon dioxide-coated substrate, a glass substrate, an ITO substrate or a quartz/chromium oxide-coated substrate) to form a resist film, irradiating thereon actinic rays or radiation such as KrF excimer laser light, electron beam or EUV light, and then subjecting the resist film to heating, development, rinsing and drying, whereby a good resist pattern can be formed.

The alkali developer which can be used in the development is an aqueous solution of alkalis (usually, from 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimethylethanolamine, triethanolamine), quaternary ammonium salts (e.g., tetramethylammonium hydroxide, tetraethylammonium hydroxide, choline) and cyclic amines (e.g., pyrrole, piperidine). This aqueous solution of alkalis may be used after adding thereto alcohols such as isopropyl alcohol or a surfactant such as nonionic surfactant, in an appropriate amount.

Among these developers, a quaternary ammonium salt is preferred, and tetramethylammonium hydroxide and choline are more preferred.

The pH of the alkali developer is usually from 10 to 15.

[Examples]

The present invention is described in greater detail below by referring to Examples, but the present invention should not be construed as being limited thereto.

[Synthesis Example 1: synthesis of Resin A-2 as resin (A)]

Acetoxystyrene, styrene and 1-phenylethyl methacrylate were charged at a ratio of 60/15/25 (by mol) and dissolved in tetrahydrofuran to prepare 100 ml of a solution having a solid content concentration of 20 mass%. Subsequently, 2 mol% of a polymerization initiator, V-65, produced by Wako Pure Chemical Industries, Ltd. was added thereto and the resulting solution was added dropwise to 10 ml of tetrahydrofuran heated at 60°C, over 4 hours in a nitrogen atmosphere. After the completion of dropwise addition, the reaction solution was heated for 4 hours, and 1 mol% of V-65 was again added, followed by stirring for 4 hours. After the completion of reaction, the reaction solution was cooled to room temperature and then crystallized in 3 L of hexane, and the precipitated white powder was collected by filtration.

This polymer was dissolved in 100 ml of acetone, 5 ml of hydrochloric acid was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to obtain the polymer as a powder. The weight average molecular weight of this powder determined by GPC was 9,500 in terms of standard polystyrene, and Mw/Mn (molecular weight distribution) was 1.89. The compositional ratio of the polymer determined from $C^{13}$NMR was 58/16/26 (by mol).

[Synthesis Example 2: synthesis of Resin A-2' as resin (A)]

Phenylthiocarbonyl disulfide (0.7 g) was added to a solution obtained by dissolving 9.8 g of acetoxystyrene, 1.6 g of styrene and 4.7 g of 1-phenylethyl methacrylate in 16 g of tetrahydrofuran and furthermore, 1.5 g of a polymerization initiator, V-65, produced by Wako Pure Chemical Industries, Ltd. was added thereto. The resulting solution was heated with stirring for 10 hours in a nitrogen atmosphere. After the completion of reaction, the reaction solution was cooled to room temperature and then crystallized in 3 L of hexane, and the precipitated white powder was collected by filtration.

This polymer was dissolved in 100 ml of acetone, 5 ml of hydrochloric acid was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to obtain the polymer as a powder. The weight average molecular weight of this powder determined by GPC was 9,500 in terms of standard polystyrene, and Mw/Mn (molecular weight distribution) was 1.05. The compositional ratio of the polymer determined from $C^{13}$NMR was 58/19/23 (by mol).

Resins shown in Table 1, of which structures are illustrated above, were synthesized in the same manner as

in Synthesis Examples 1 and 2. Here, A-2' was synthesized using living radical polymerization.

In Table 1, the ratio of repeating units is a ratio of repeating units starting from the left in the structure of each resin illustrated above.

Table 1

| Resin | Repeating Unit (mol%) | Weight Average Molecular Weight | Dispersity |
|---|---|---|---|
| A-2 | 58/16/26 | 9500 | 1.89 |
| A-4 | 65/15/20 | 10500 | 1.65 |
| A-6 | 65/15/20 | 8000 | 1.59 |
| A-8 | 65/20/15 | 9000 | 1.75 |
| A-12 | 68/16/16 | 10000 | 1.75 |
| A-14 | 70/20/10 | 9500 | 1.82 |
| A-16 | 70/10/20 | 7500 | 1.65 |
| A-20 | 65/35 | 8900 | 1.52 |
| A-22 | 63/37 | 7480 | 1.59 |
| A-24 | 72/28 | 7600 | 1.75 |
| A-26 | 75/25 | 8900 | 1.79 |
| A-28 | 69/31 | 9600 | 1.63 |
| A-30 | 64/36 | 8100 | 1.85 |
| A-32 | 74/26 | 7600 | 1.84 |
| A-34 | 70/10/20 | 9400 | 1.74 |
| A-36 | 74/10/16 | 8200 | 1.69 |
| A-38 | 64/15/21 | 10200 | 1.58 |
| A-40 | 60/14/26 | 10700 | 1.71 |
| A-42 | 57/19/24 | 8300 | 1.83 |
| A-44 | 54/24/22 | 7800 | 1.79 |
| A-46 | 51/20/29 | 9900 | 1.69 |
| A-48 | 65/20/15 | 6900 | 1.66 |
| A-2' | 58/19/23 | 9500 | 1.05 |

The resins containing at least one repeating unit selected from a repeating unit represented by formula (A1) and a repeating unit represented by formula (A2), of which solubility in an alkali developer increases under the action of an acid, and the acid generators, used in Examples of the present invention, all were synthesized by a known synthesis method such as synthesis method described in JP-A-2002-27806.

[Examples 1 to 16 and Comparative Examples 1 to 9]

(1) Preparation and Coating of Positive Resist

| | |
|---|---|
| Resin A-2 | 0.93 g |
| Sulfonic Acid Generator B-2 | 0.07 g |

These components were dissolved in 8.8 g of propylene glycol monomethyl ether acetate, and 0.003 gofD-1 (see below) as the organic basic compound and 0.001 g of Megafac F176 (produced by Dainippon Ink & Chemicals,

Inc., hereinafter simply referred to as "W-1") as the surfactant were further added thereto and dissolved. The obtained solution was microfiltered through a membrane filter having a pore size of 0.1 μm to obtain a resist solution.

Preparation and coating of resist were performed using the compounds shown in Table 2 to obtain a resist film. The film thickness was set to 0.40 μm.

[Resin]

R-1*

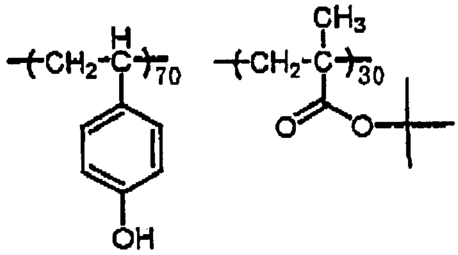

Weight average molecular weight: 9,300

R-2*

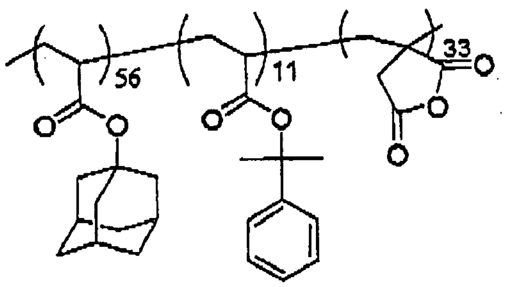

Weight average molecular weight: 9,100

[Basic Compound]

D-46; Tri-n-butylamine (tertiary amine)
D-47: Tri-n-octadecylamine (tertiary amine)

Here, D-1 to D-40 are compounds illustrated above.

[Comparative Basic Compound]

E-1: Tetra-(n-butyl)ammonium hydroxide (quaternary ammonium salt)
E-2: 2,6-Diisopropylaniline (primary amine)
E-3 Di-n-dodecanylamine (secondary amine)

[Surfactant]

W-1: Fluorine-containing surfactant, Megafac F176 (produced by Dainippon Ink & Chemicals, Inc.)
W-2: Fluorine/silicon-conmBing surfactant, Megafac R08 (produced by Dainippon Ink & Chemicals, Inc.)

(2) Formation of Positive Pattern

The resist film obtained was pattern-exposed using a KrF excimer laser stepper (FPA-3000EX-5, manufactured by Canon Inc., wavelength: 248 nm). After the exposure, the resist film was baked at 110°C for 90 seconds, dipped in an aqueous 2.38 mass% tetramethylammonium hydroxide (TMAH) solution for 60 seconds, rinsed with water for 30 seconds and then dried. The obtained pattern was evaluated by the following methods.

(2-1) Sensitivity

The cross-sectional profile of the pattern obtained was observed using a length-measuring electron microscope (S-9380, manufactured by Hitachi, Ltd.). The minimum irradiation energy when resolving dense holes of 0.18 μm was taken as the sensitivity,

(2-2) Side Lobe Margin

The resist pattern obtained in the same manner as above was observed by a scanning electron microscope (S-4300, manufactured by Hitachi, Ltd.) and the surface of the resist between hole patterns was inspected. The exposure amount when roughness/dent was observed on the surface was taken as the minimum irradiation energy allowing for generation of side lobe. The side lobe margin is defined as follows: side lobe margin (%) = ((minimum irradiation energy allowing for generation of side lobe - sensitivity)/ sensitivity -1)x 1 00.

Preparation and coating of resist and evaluation by exposure with a KrF excimer laser were performed using the compounds shown in Table 1, The evaluation results are shown in Table 2.

Table 2

| Example | Resin | Sulfonic Acid Generator | Basic Compound (0.003 g) | Others (0.001 g) | Sensitivity ($mJ/cm^2$) | Side Lobe Margin (%) |
|---|---|---|---|---|---|---|
| 1 | A-2 (0.93 g) | B-2 (0.07 g) | D-1 | W-1 | 9.4 | 5.1 |
| 2 | A-4 (0.95 g) | B-4 (0.07 g) | D-3 | W-1 | 10.8 | 6.0 |
| 3 | A-12 (0.95 g) | B-16 (0.07 g) C-1 (0.02 g) | D-3 | W-2 | 9.8 | 6.5 |
| 4 | A-14 (0.95g) | B-17 (0.07g) C-8 (0.02 g) | D-6 | W-1 | 10.2 | 6.6 |
| 5 | A-3 (0.93 g) | B-58 (0.07 g) | D-6 | W-1 | 9.4 | 6.0 |
| 6 | A-3 (0.93 g) | B-59 (0.07 g) | D-18 | W-1 | 10.2 | 5.6 |
| 7 | A-5 (0.55 g) R-1 (0.35 g) | B-16 (0.07 g) | D-22 | W-2 | 9.4 | 6.1 |

(continued)

| Example | Resin | Sulfonic Acid Generator | Basic Compound (0.003 g) | Others (0.001 g) | Sensitivity ($mJ/cm^2$) | Side Lobe Margin (%) |
|---|---|---|---|---|---|---|
| 8 | A-6 (0.55 g) R-4 (0.35 g) | B-17 (0.07 g) | D-22 | W-1 | 10.0 | 6.3 |
| 9 | A-7 (0.55 g) R-7 (0.35 g) | B-2 (0.07 g) | D-23 | W-1 | 9.9 | 6.3 |
| 10 | A-8 (0.55 g) R-8 (0.35 g) | B-4 (0.07 g) | D-23 | W-1 | 10.5 | 6.5 |
| 11 | A-9 (0.35 g) R-9 (0.55 g) | B-16 (0.07 g) | D-27 | W-2 | 9.1 | 5.3 |
| 12 | A-10 (0.55 g) R-11 (0.35 g) | B-2 (0.07 g) | D-32 | W-1 | 10.9 | 5.3 |
| 13 | A-11 (0.95 g) | B-2 (0.03 g) B-58 (0.02 g) | D-38 | W-1 | 9.9 | 5.1 |
| 14 | A-12 (0.85 g) | B-81 (0.03 g) | D-40 | W-2 | 10.5 | 5.6 |
| 15 | A-4 (0.93 g) | B-4 (0.07 g) | D-46 | W-1 | 10.3 | 3.8 |
| 16 | A-12 (0.93 g) | B-81 (0.03 g) | D-47 | W-2 | 9.9 | 3.9 |
| Comparative Example 1 | R-1* (0.93 g) | B-2 (0.07 g) | D-4 | W-2 | 12.4 | 2.5 |
| Comparative Example 2 | R-1* (0.93 g) | B-2 (0.07 g) | D-6 | W-1 | 10.2 | 2.7 |
| Comparative Example 3 | R-1* (0.93 g) | B-2 (0.07 g) | D-18 | W-1 | 10.9 | 1.9 |
| Comparative Example 4 | R-1* (0.93 g) | B-4 (0.07 g) | D-23 D-25 | W-1 | 12.1 | 2.9 |
| Comparative Example 5 | R-1* (0.93 g) | B-4 (0.07 g) | D-27 | W-1 | 9.8 | 2.0 |
| Comparative Example 6 | R-1* (0.93 g) | B-4 (0.07 g) | D-40 | W-1 | 9.7 | 2.1 |
| Comparative Example 7 | R-1* (0.93 g) | B-2 (0.07 g) | E-2 | W-1 | 10.3 | 1.2 |

(continued)

| Example | Resin | Sulfonic Acid Generator | Basic Compound (0.003 g) | Others (0.001 g) | Sensitivity ($mJ/cm^2$) | Side Lobe Margin (%) |
|---|---|---|---|---|---|---|
| Comparative Example 8 | R-1* (0.93 g) | B-4 (0.07 g) | E-3 | W-2 | 10.4 | 1.3 |
| Comparative Example 9 | R-2* (0.93 g) | B-4 (0.07 g) | E-3 | W-2 | 15.9 | 1.0 |

It is seen from Table 2 that as regards the pattern formation by the KrF excimer laser exposure, the positive resist composition of the present invention is excellent in the side lobe margin as compared with the combinations in Comparative Examples 1 to 9.

[Examples 17 and 18 and Comparative Example 10: Production of Pattern by Electron Beam and Evaluation]

The positive resist solution prepared as above was uniformly coated on a hexamethyldisilazane-treated silicon wafer by using a spin coater and then dried under heating at 120°C for 90 seconds to form a positive resist film having a thickness of 0.15 μm. This resist film was then irradiated with electron beams by using an electron beam image-drawing apparatus (HL750, manufactured by Hitachi Ltd., accelerating voltage: 50 KeV). After the irradiation, the resist film was baked at 110°C for 90 seconds, dipped in an aqueous 2.38 mass% tetramethylammonium hydroxide (TMAH) solution for 60 seconds, rinsed with water for 30 seconds and dried. The obtained pattern was evaluated by the following methods.

[Sensitivity]

The cross-sectional profile of the pattern obtained was observed using a scanning electron microscope (S-4800, manufactured by Hitachi, Ltd.). The minimum irradiation energy when resolving a 150-nm line (line:space =1:1) was taken as the sensitivity.

Table 3

| | Resin | Sulfonic Acid Generator | Base (0.0025 g) | Others (0.001 g) | Sensitivity ($\mu C/cm^2$) |
|---|---|---|---|---|---|
| Example 17 | A-14 (0.95 g) | B-17 (0.05 g) C-8 (0.01 g) | D-6 | W-1 | 10.5 |
| Example 18 | A-7 (0.55 g) R-7 (0.35 g) | B-2 (0.05 g) | D-23 | W-1 | 10.0 |
| Comparative Example 10 | R-1* (0.93 g) | B-2 (0.05 g) | D-4 | W-2 | 15.5 |

[Examples 19 and 20 and Comparative Example 11: Production of Pattern by EUV Light and Evaluation]

The positive resist solution prepared as above was uniformly coated on a hexamethyldisilazane-treated silicon wafer by using a spin coater and then dried under heating at 120°C for 90 seconds to form a positive resist film having a thickness of 0.13 μm. This resist film was subjected to surface exposure with EUV light (wavelength: 13 nm) by changing the exposure amount in steps of 0.5 mJ in the range from 0 to 15.0 mJ and further baked at 110°C for 90 seconds. Thereafter, the dissolution rate at each exposure amount was measured using an aqueous 2.38 mass% tetramethylammonium hydroxide (TMAH) solution to obtain a sensitivity curve. The exposure amount when the dissolution rate of the resist was saturated in the sensitivity curve above was taken as the sensitivity and also, the dissolution contrast (γ value) was calculated from the gradient in the straight line part of the sensitivity curve. As the γ value is larger, the dissolution contrast is more excellent.

The results are shown in the Table below.

Table 4

| | Resin | Sulfonic Acid Generator | Base (0.0025 g) | Others (0.001 g) | Sensitivity (mJ/cm$^2$) | γ Value |
|---|---|---|---|---|---|---|
| Example 19 | A-14 (0.95 g) | B-17 (0.05 g) C-8 (0.01 g) | D-6 | W-1 | 11.5 | 9.6 |
| Example 20 | A-7 (0.55 g) R-7 (0.35 g) | B-2 (0.05 g) | D-23 | W-1 | 11.0 | 9.4 |
| Comparative Example 11 | R-1* (0.93 g) | B-2 (0.05 g) | D-4 | W-2 | 14.5 | 6.5 |

It is seen that as regards the patterning by electron beam and EUV light, the positive resist composition of the present invention exhibits good performances.

According to the present invention, as regards the pattern formation by the irradiation of KrF excimer laser light, EUV light or the like, a positive resist composition excellent in the sensitivity, resolving power and pattern profile and further excellent in the side lobe margin, and a pattern forming method using the composition can be provided.

The entire disclosure of each and every foreign patent application from which the benefit of foreign priority has been claimed in the present application is incorporated herein by reference, as if fully set forth.

## Claims

1. A positive resist composition, which comprises:

(A) a resin containing a repeating unit represented by formula (I);
(B) a compound capable of generating an acid upon irradiation with actinic rays or radiation; and
(C) a tertiary amine compound:

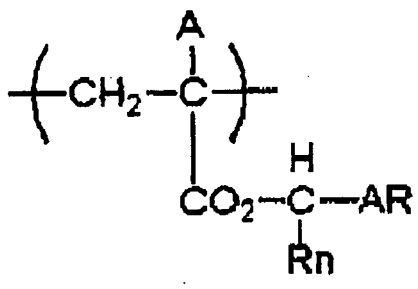

(I)

wherein AR represents a substituted or unsubstituted benzene ring or a substituted or unsubstituted naphthalene ring;
Rn represents a substituted or unsubstituted alkyl group, a substituted or unsubstituted cycloalkyl group or a substituted or unsubstituted aryl group; and
A represents an atom or group selected from the group consisting of a hydrogen atom, a substituted or unsubstituted alkyl group, a substituted or unsubstituted cycloalkyl group, a halogen atom, a cyano group and a substituted or unsubstituted alkyloxycarbonyl group.

2. The positive resist composition according to claim 1,
wherein (C) the tertiary amine compound is represented by formula (II):

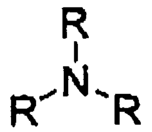

(II)

wherein three R's may be the same or different and each represents an alkyl or cycloalkyl group having a carbon number of 20 or less, which may contain a hydroxyl group, an ether group, a carbonyl group, an ester group, a lactone group, a carbonate group or a cyano group.

**3.** The positive resist composition according to claim 2,
wherein in the tertiary amine compound represented by formula (II), three R's are the same and each has a carbon number of 8 to 16.

**4.** The positive resist composition according to claim 2,
wherein in the tertiary amine compound represented by formula (II), at least one R is a cycloalkyl group.

**5.** The positive resist composition according to claim 1,
wherein the resin (A) further contains a repeating unit represented by formula (A1):

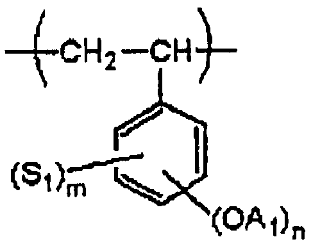

(A1)

wherein n represents an integer of 0 to 3;
m represents an integer of 0 to 3, provided that m+m:S;
$A_1$ represents a group containing a group capable of decomposing under an action of an acid; and
$S_1$ represents a substituent, and when a plurality of $S_1$'s are present, the plurality of $S_1$'s may be the same or different.

**6.** The positive resist composition according to claim 5,
wherein in the repeating unit represented by formula (A1), the group containing a group capable of decomposing under an action of an acid represented by $A_1$ is an acetal group or a ketal group.

**7.** The positive resist composition according to claim 1,
wherein AR represents a benzene or a para-methyl benzene.

**8.** A pattern forming method, which comprises:

forming a resist film from the positive resist composition according to claim 1; and
exposing and developing the resist film.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7234511 A
- US 5561194 A
- JP 11095434 A
- US 3849137 A
- DE 3914407
- JP 63026653 A
- JP 55164824 A
- JP 62069263 A
- JP 63146038 A
- JP 63163452 A
- JP 62153853 A
- JP 63146029 A
- US 3779778 A
- EP 126712 A
- JP 2002027806 A
- JP 62036663 A
- JP 61226746 A
- JP 61226745 A
- JP 62170950 A
- JP 63034540 A
- JP 7230165 A
- JP 8062834 A
- JP 9054432 A
- JP 9005988 A
- JP 2002277862 A
- US 5405720 A
- US 5360692 A
- US 5529881 A
- US 5296330 A
- US 5436098 A
- US 5576143 A
- US 5294511 A
- US 5824451 A
- JP 2002090991 A
- JP 4151156 A
- JP 4162040 A
- JP S197148 A
- JP 5005995 A
- JP 6194834 A
- JP 8146608 A
- JP 10083079 A
- EP 622682 A
- JP 7069611 B
- US 5294680 A
- JP 6118631 A
- JP 6118656 A
- JP 8087115 A
- JP 8179509 A